# EUROPEAN PATENT SPECIFICATION

(11) **EP 4 022 595 B1**
(45) Date of publication and mention of the grant of the patent: **02.07.2025**
(21) Application number: 20858479.7
(22) Date of filing: 25.08.2020
(51) Int. Cl.: G09F 13/22, G09F 13/04, G09F 21/04, G09F 27/00, H04N 5/645, H05K 7/20, G02F 1/1333, G09F 19/22

(54) **SOLAR POWERED DISPLAY ASSEMBLIES**
SOLARBETRIEBENE ANZEIGEANORDNUNGEN
ENSEMBLES D'AFFICHAGE À ÉNERGIE SOLAIRE

(30) Priority: 27.08.2019 US 201962892104 P; 07.10.2019 US 201962911806 P; 29.06.2020 US 202016915774
(43) Date of publication of application: 06.07.2022
(73) Proprietor: Manufacturing Resources International, Inc., Alpharetta, GA 30005 (US)
(72) Inventor: DUNN, William, Alpharetta, GA 30005 (US); FRASCHILLA, Gerald, Alpharetta, GA 30005 (US); BARTHOLMAE, Jack, Alpharetta, GA 30005 (US); BENNETT, Douglas, Alpharetta, GA 30005 (US)
(74) Representative: FRKelly
(86) International application number: PCT/US2020/047747
(87) International publication number: WO 2021/041381

(56) References cited:
- KR-B1- 101 444 022
- US-A1- 2011 298 841
- US-A1- 2012 224 116
- US-A1- 2015 381 922
- US-A1- 2016 041 423
- US-A1- 2018 293 921
- US-B1- 9 121 391

## Description

### TECHNICAL FIELD

Exemplary embodiments relate generally to solar powered display assemblies and systems and methods for powering the same.

### BACKGROUND AND SUMMARY OF THE INVENTION

Electronic displays are increasingly replacing physical billboards, bulletins, posters, flyers, banners, and other physical signage for public announcements, advertising, and the like. It is known to provide such physical signage along sidewalks, along roadsides, at bus shelters, on poles, at drive throughs, on vehicle toppers, and the like. Ruggedized displays have also been provided for indoor, outdoor, and semi-outdoor use. Such displays may protect the electronic displays and related components from the elements, vandalism, theft, and the like and may be configured to display public announcements, advertising, and the like. Examples of such displays include those available from Manufacturing Resources International, Inc. of Alpharetta, Georgia (https://mri-inc.net/). These displays may be provided on sidewalks, on the ground, in windows, on sidewalks, at bus shelters, at drive throughs (such as for quick service restaurants ("QSRs")), on the tops of vehicles, and the like to replace physical signage.

Advancements in solar energy technology have made solar panels more compact and efficient. Displays require electrical power for operation. For example, such displays may include lights, electronic displays, fans and other cooling equipment, computing devices, electrical circuitry and other electrically powered equipment which requires electrical power for operation. For ground mounted units, power is generally provided by the electrical grid. Increasing public interest in alternative energy sources, such as solar power, creates a desire for displays which do not draw power from the electrical grid, or at least not as much. Further, the cost to power such displays may be significant.

For vehicle mounted or other mobile units, power is generally supplied by the vehicle battery. While vehicle toppers may provide an extra source of revenue for vehicle drivers or companies, generally by displaying advertising for others, the extra weight of a vehicle topper may reduce fuel efficiency, which negate some or all of the extra revenue. The use of battery power may further provide added strain on battery capacity, particularly where a vehicle is not running.

What is needed is a solar powered display assembly. Solar powered display assemblies, and systems and methods for powering the same, are provided.

Solar powered electronic display assemblies are provided which may be configured for mounting to a sidewalk, to a bench, to a wall, in a window, to a bus shelter, to a ground surface, to a parking lot, to street furniture, at a drive through (e.g., for QSR), to a pole, to a vehicle (e.g., taxi cab, a personal vehicle, a commercial vehicle, a limousine, a town car, a bus, an SUV, a rideshare vehicle, a delivery vehicle, or the like), some combination thereof, or the like. Each electronic display assembly may comprise one or more display units. Any number, type, size, and orientation of such display units may be utilized. One or more solar energy harvesting devices may be provided as part of the assembly and may be in electrical connection with the one or more display units and/or other components of the assemblies.

Solar energy harvesting devices may be mounted or connected to housings for the display units, street furniture, nearby structures, canopies for drive throughs, roof racks or other mounting devices or support structure for vehicles, some combination thereof, or the like. While such solar energy harvesting devices may generally be mounted above the display units, other locations may be utilized to improve visibility, aesthetics, and/or aerodynamics. One or more supports may connect, directly or indirectly, such solar energy harvesting devices to the display units.

The solar energy harvesting devices are located, sized, shaped, and/or otherwise configured to cast shade on at least portions of some or all of the display units. Alternatively, or additionally, the solar energy harvesting devices may be located, sized, shaped, and/or otherwise configured to provide sufficient clearance for performing maintenance efforts to the assemblies. The solar energy harvesting devices have a larger footprint than the display units. The casing of shade may improve the appearance of images displayed at the display units, provide shade for viewers, reduce solar loading, and/or lower brightness requirements, among other benefits.

Power generated by the solar energy harvesting devices may be used to power the display assemblies, or select components thereof such as, when conditions are sufficiently sunny. Excess energy may be stored at one or more energy storage devices (e.g., batteries) and/or returned power sources such as, but not limited to, the power grid. When the power generated by the one or more solar energy harvesting devices is insufficient to power the display assemblies, or select components thereof, energy may be drawn from the one or more energy storage devices and/or other power sources, such as, but not limited to, the power grid.

The display units may be configured to directly accept both AC and DC power. Alternatively, or additionally, the display units may be configured to run entirely on DC power. DC power generated by the solar energy harvesting devices may be supplied directly to the display units. When the power generated by the one or more solar energy harvesting devices is insufficient to power the electronic display assemblies or otherwise meet expected power demands, only the additional energy required may be drawn from alternative power sources. This power may be directly supplied to the display units in AC form, DC form, and/or converted to DC power as needed. This may improve overall energy efficiency of the display assembly.

Further features and advantages of the systems and methods disclosed herein, as well as the structure and operation of various aspects of the present disclosure, are described in detail below with reference to the accompanying figures.

### BRIEF DESCRIPTION OF THE DRAWINGS

In addition to the features mentioned above, other aspects of the present invention will be readily apparent from the following descriptions of the drawings and exemplary embodiments, wherein like reference numerals across the several views refer to identical or equivalent features, and wherein:
**FIGURE 1** is a front perspective view of an exemplary vehicle mounted display unit ("VMDU") with an exemplary solar energy harvesting device with certain internal components revealed and illustrated in simplified form;
**FIGURE 2** is a left side perspective view of the VMDU of figure 1;
**FIGURE 3** is an enlarged, right side perspective view of the VMDU of figure 1;
**FIGURE 4** is a top perspective view of the VMDU of figure 1;
**FIGURE 5** is a front perspective view of another exemplary VMDU with another exemplary solar energy harvesting device with certain internal components revealed and illustrated in simplified form;
**FIGURE 6** is an enlarged, right side perspective view of the VMDU of figure 5;
**FIGURE 7** is a left side view of the VMDU of figure 5;
**FIGURE 8** is a perspective view of another exemplary VMDU with another exemplary solar energy harvesting device with certain internal components revealed and illustrated in simplified form;
**FIGURE 9** is a top sectional view of an exemplary cooling system for the VMDUs of figures 1-8;
**FIGURE 10** is a flowchart with exemplary logic for operating the VMDUs of figures 1-9;
**FIGURE 11** is a flowchart with other exemplary logic for operating the VMDU of figures 1-9;
**FIGURE 12** is a perspective view of an exemplary bus shelter with display units and solar energy harvesting devices (the "bus shelter assembly");
**FIGURE 13** is a left side view of the bus shelter assembly of figure 12 with certain internal components revealed and illustrated in simplified form;
**FIGURE 14** is a perspective view of an exemplary surface mounted electronic display assembly with solar energy harvesting devices (the "surface mounted assembly");
**FIGURE 15** is a rear view of the surface mounted assembly of figure 14 with certain internal components revealed and illustrated in simplified form;
**FIGURE 16** is a perspective view of another exemplary surface mounted assembly;
**FIGURE 17** is a perspective view of another exemplary surface mounted assembly;
**FIGURE 18** is a perspective view of another exemplary surface mounted assembly;
**FIGURE 19** is a perspective view of an exemplary pole mounted electronic display assembly with solar energy harvesting devices (the "pole mounted assembly");

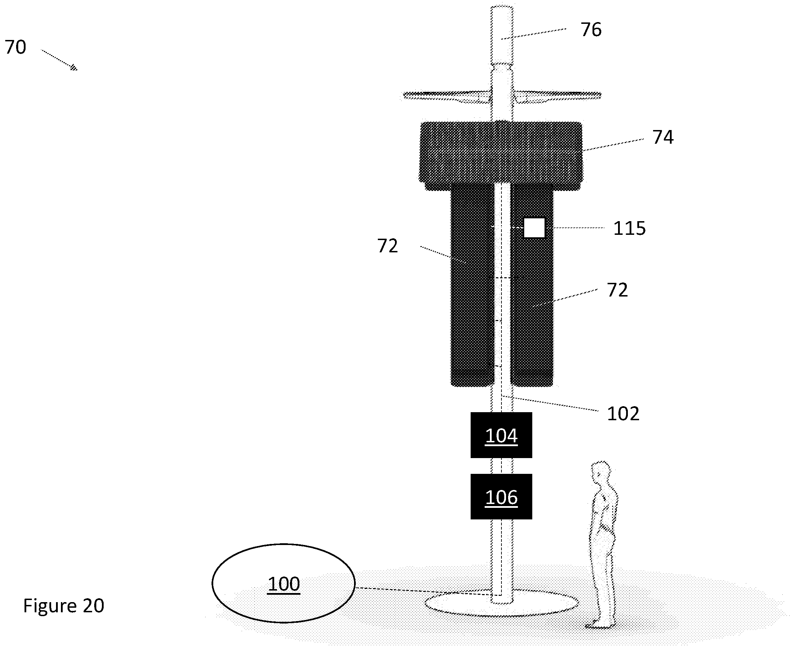

**FIGURE 20** is a front view of the pole mounted assembly of figure 19 with certain internal components revealed and illustrated in simplified form;

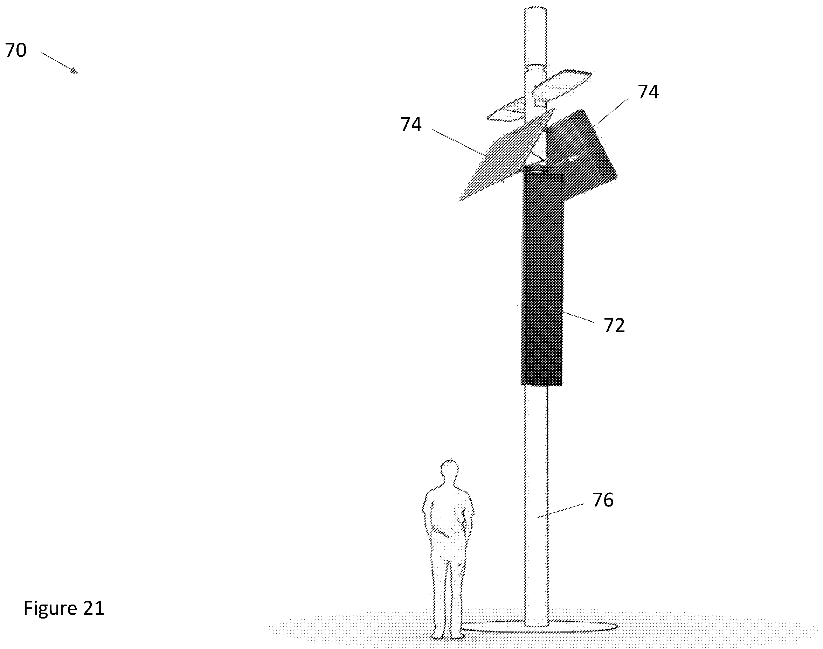

**FIGURE 21** is a perspective view of another exemplary pole mounted assembly;

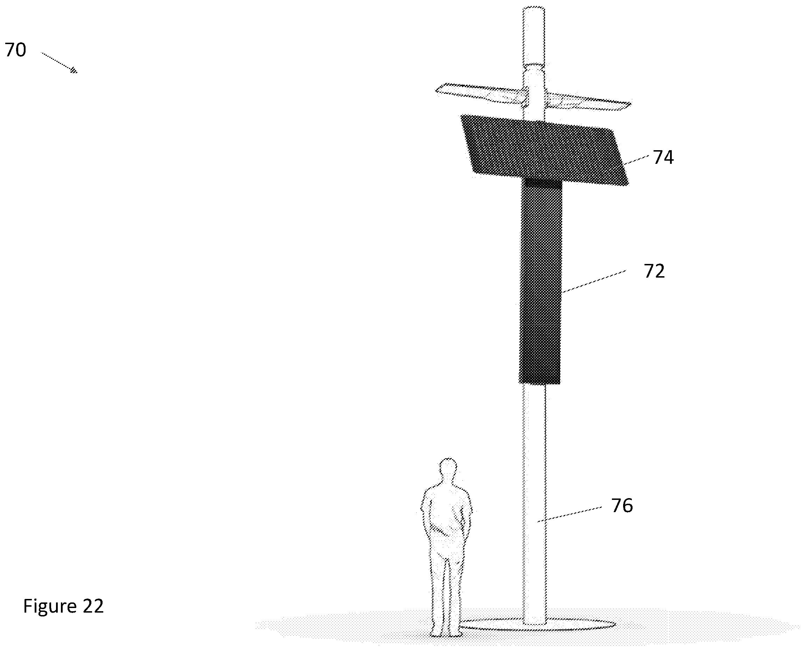

**FIGURE 22** is a perspective view of another exemplary pole mounted assembly;

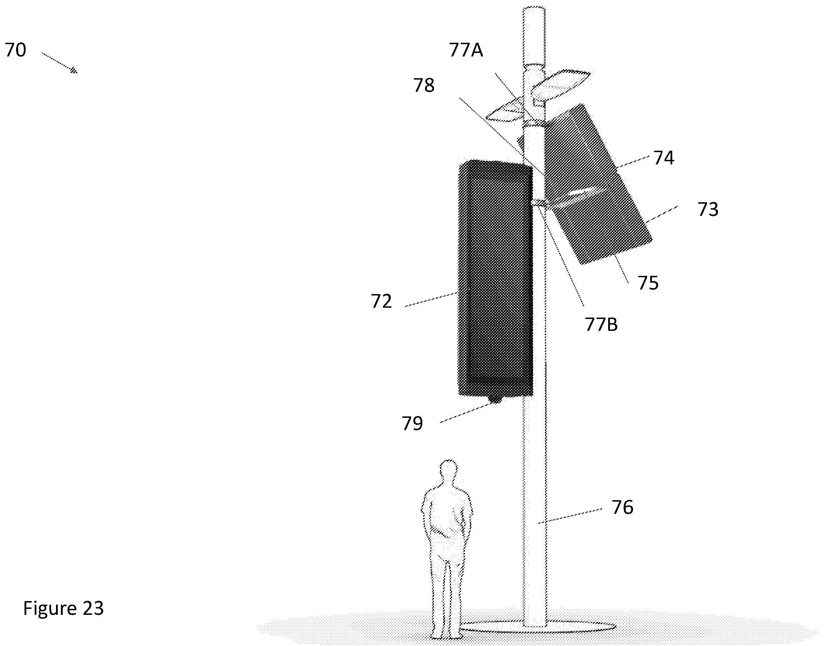

**FIGURE 23** is a perspective view of another exemplary pole mounted assembly;

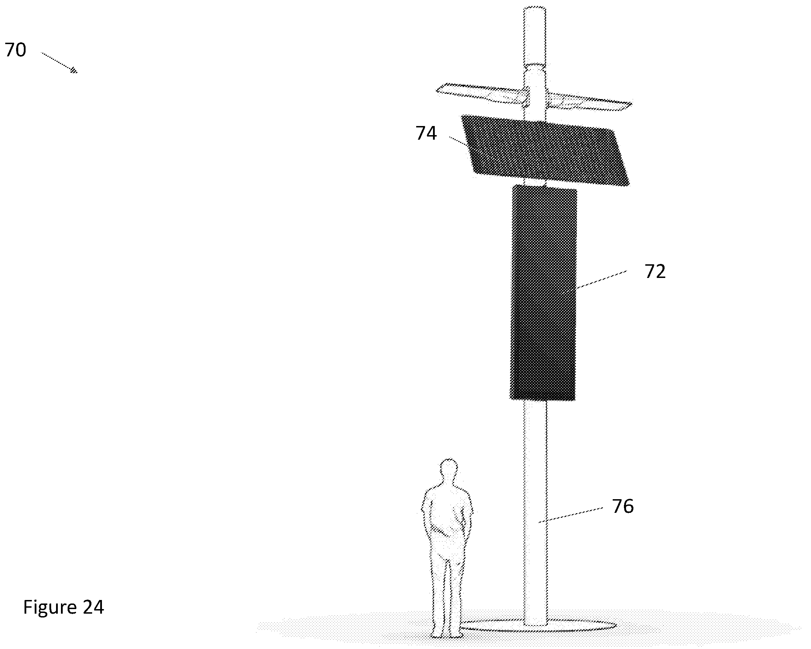

**FIGURE 24** is a perspective view of another exemplary pole mounted assembly;
**FIGURE 25** is a left side view of another exemplary pole mounted assembly;
**FIGURE 26** is a perspective view of an exemplary drive through canopy with an electronic display assembly and solar energy harvesting devices (the "canopy assembly");
**FIGURE 27** is a rear view of the canopy assembly of figure 26 with certain internal components revealed and illustrated in simplified form;
**FIGURE 28** is a perspective view of the canopy assembly of figure 26 with the solar energy harvesting devices in a second position;
**FIGURE 29** is a perspective view of another exemplary canopy assembly;
**FIGURE 30** is a flow chart with exemplary logic in accordance with the present invention;
**FIGURE 31** is a simplified electrical schematic diagram in accordance with the present invention;
**FIGURE 32** is a perspective view of another exemplary surface mounted assembly;
**FIGURE 33** is a top perspective view of another exemplary surface mounted assembly with solar energy harvesting devices;
**FIGURE 34** is an exemplary electrical schematic in accordance with the present invention; and
**FIGURE 35** is another exemplary electrical schematic in accordance with the present invention.

### DETAILED DESCRIPTION OF EXEMPLARY EMBODIMENT(S)

Various embodiments of the present invention will now be described in detail with reference to the accompanying drawings. In the following description, specific details such as detailed configuration and components are merely provided to assist the overall understanding of these embodiments of the present invention. Therefore, it should be apparent to those skilled in the art that various changes and modifications of the embodiments described herein can be made without departing from the scope of the present invention. In addition, descriptions of well-known functions and constructions are omitted for clarity and conciseness.

Embodiments of the invention are described herein with reference to illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

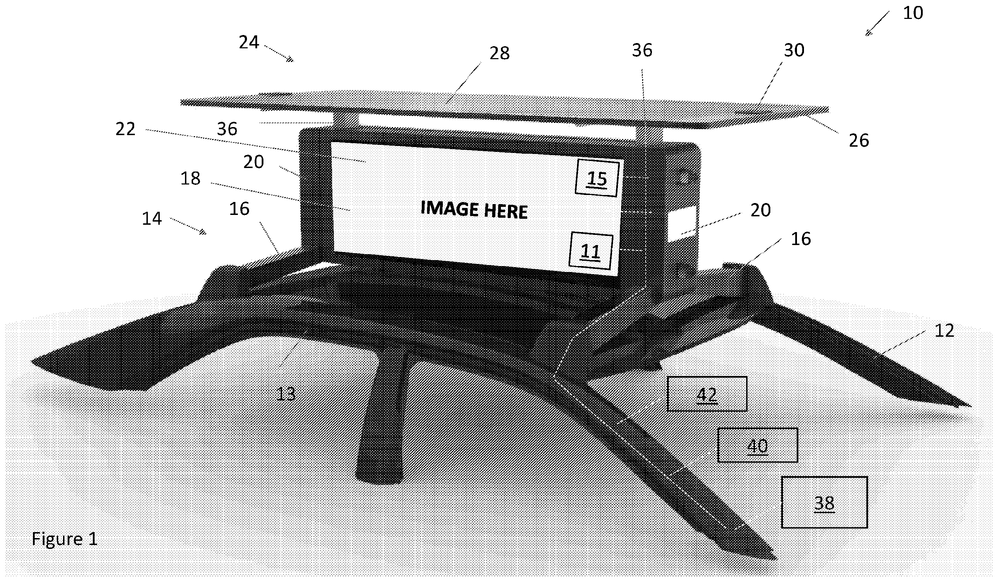

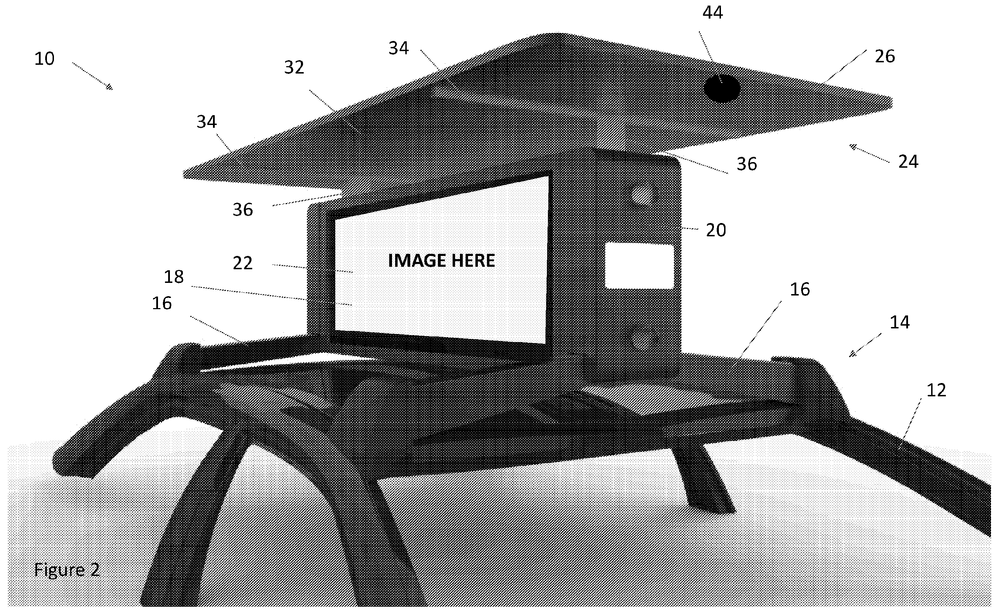

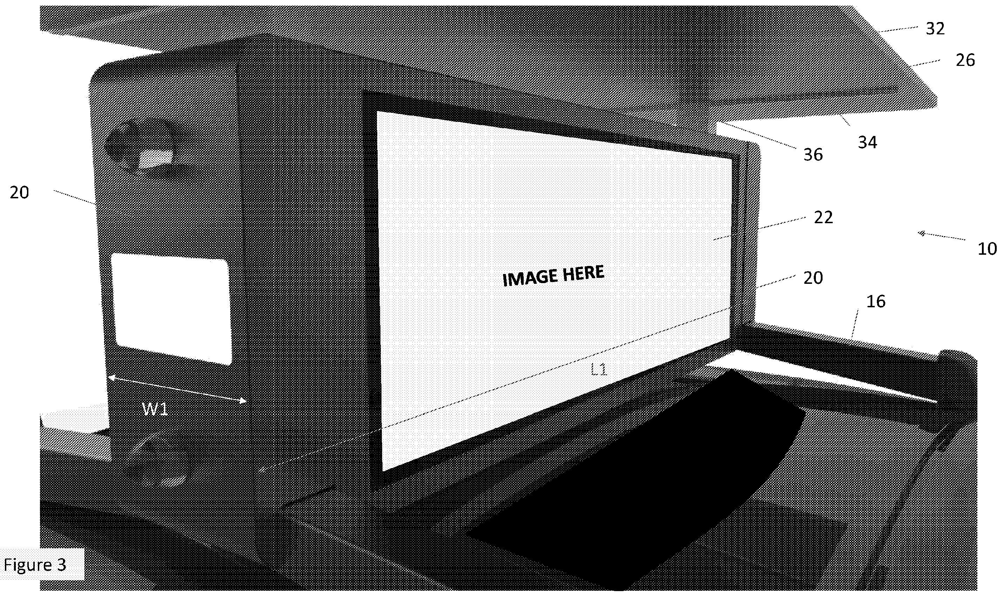

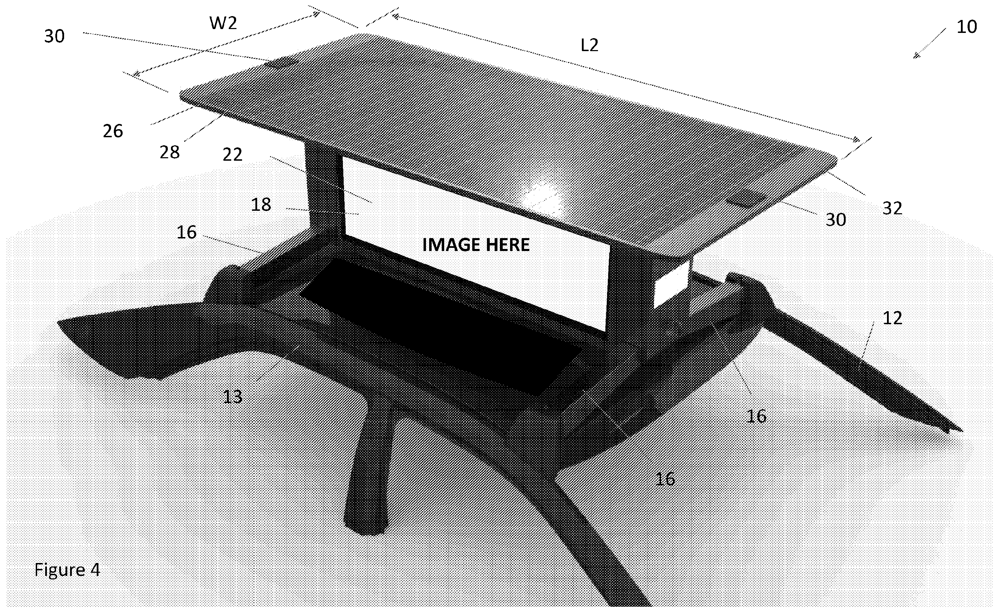

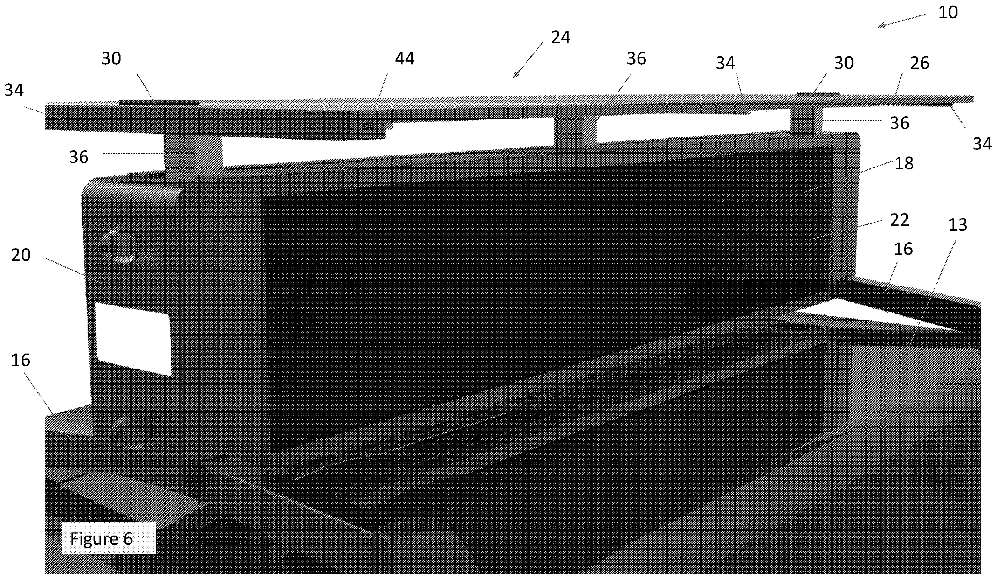

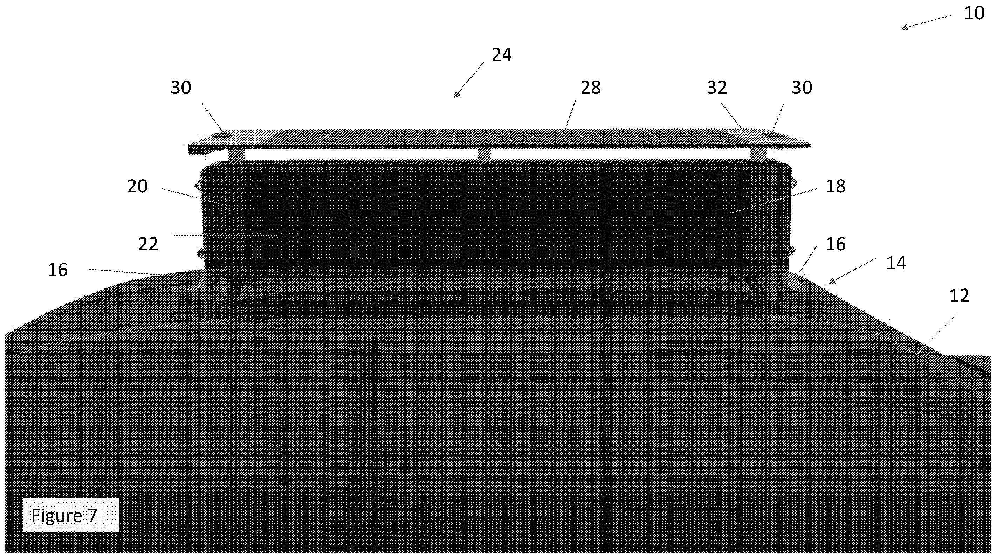

**FIGURE 1** through **FIGURE 4** illustrate an exemplary VMDU 10. The VMDU 10 may be employed to display information to the public along public roadways, such as, for example, advertisements, public service announcements and the like. Further, the VMDU 10 may be fabricated in any size and shape, may be mounted to a vehicle 12 directly or indirectly, and may be mounted in any orientation (e.g., parallel to the longitudinal dimension of the vehicle 12, angled, and/or otherwise). Further, while the VMDUs 10 of figures 1-7 are shown as being mounted to the roof 13 of a vehicle 12, the VMDUs 10 may be mounted to other portions of the vehicle 12 (e.g., hood and/or trunk) as well.

The vehicle 12 may be gasoline powered, hybrid powered (e.g., gasoline and electric), diesel powered, electric powered, fuel cell powered, hydrogen powered, human powered, some combination thereof, and/or the like. Further, the vehicle 12 may be any type of vehicle, including for example without limitation, a personal vehicle, a commercial vehicle, a rideshare vehicle, a taxi cab, a limousine, a town car, a bus, an SUV, a sedan, a delivery vehicle, a trailer, a van, a motorcycle, a scooter, a tricycle, or the like.

As shown, the VMDU 10 may be indirectly mounted to a vehicle 12 by way of a mounting system 14. The mounting system 14 may comprise one or more crossbars 16. The crossbars 16 may be configured for securement to a roof 13 of a vehicle 12. The crossbars 16 may be fabricated in any size, shape (e.g., cross-section), and type. The crossbars 16 may be configured to provide a sufficient degree of strength and rigidity to securely support the VMDU 10.

The mounting system 14 may further comprise one or more bolts, screws, brackets, fasteners, adapters, some combination thereof, or the like for mounting the VMDU 10 to the crossbars 16 (e.g., mounting the VMDU housing 20 to the crossbars 16) and/or the crossbars 16 to the vehicle 12. Alternatively, or additionally, adhesive, welding, bonding, some combination thereof, or other joining techniques may be utilized.

One or more supports 36, which may vary in terms of size and shape (e.g., substantially rectangular), are provided. The supports 36 extend vertically between the housing 20 and each of one or more solar energy harvesting devices 24 to elevate a bottom surface of the solar energy harvesting devices 24 from an upper surface of the VMDU 10. Doing so may facilitate access to the VMDU 10, which may be useful for maintenance and servicing efforts. In one example, the supports 36 may be mounted to the housing 20 at a first end. The supports 36 may be mounted to lifting eyes located on the housing 20. In other exemplary embodiments, the supports 36 may extend into or through some or all of the housing 20 and may be mounted to one or more internal structural components of the VMDU 10 and/or one or more components of the mounting system 14 (e.g., onto the crossbars 16). In exemplary embodiments, a first support 36 may be placed on a proximal portion of the VMDU 10, and a second support 36 may be placed on a distal portion of the VMDU 10. Other quantities and arrangements of supports 36 may also be utilized. The mounting of the supports 36, and/or other components described herein, may be performed by fasteners (such as, but not limited to, rivet nuts, bolts, screws, nails, some combination thereof, or the like), adhesives, welding, bonding, some combination thereof, or the like.

In some non-limiting examples, the VMDU 10 may comprise one or more side assemblies 22. Each side assembly 22 may comprise an electronic display 18. Each side assembly 22 may be configured to swing or otherwise rotate, pivot, or move outwardly to facilitate access to the components located inside the side assembly 22 and/or other portions of the VMDU 10, which may include signage, cooling pathways, lights, fans, electronic displays, mounting components, structural components, electrical circuitry, various electronics for operating the VMDU 10 and/or the solar energy harvesting device 24, some combination thereof, or the like. Each side assembly 22 may comprise an electronic display layer, a transparent cover panel, a backlight, some combination thereof, or the like. The backlight may comprise direct backlighting, edge lighting, some combination thereof, or the like. In other exemplary embodiments, a separate backlight may not be required as the electronic display 18 may be an emissive type display, such as, but not limited to, organic light emitting diode type displays. The electronic display 18 may be any type of electronic display such as, but not limited to, liquid crystal, organic light emitting diode, QLED, light emitting diode, cathode ray tube, plasma, some combination thereof, or the like.

At least 5 inches of clearance is provided between an upper surface of the VMDU 10 and a lower surface of the solar energy harvesting device 24, though any distance, or varying distances, may be utilized. This clearance is provided to facilitate the casting of shade on the electronic display 18, the VMDU 10, the interior of the vehicle 12, some combination thereof, or the like, thereby preventing the VMDU from experiencing excessive solar (e.g., thermal) loading and/or to provide certain desirable aerodynamic effects.

Stiffeners 34 are provided. The stiffeners 34 extend horizontally along a lower surface of the substrate 32. The stiffeners 34 may extend from either side of each of the one or more supports 36. The stiffeners 34 shown extend substantially across the entire width W₂ of the solar energy harvesting device 24, but this is not required. In exemplary embodiments, the stiffeners 34 may be sandwiched between an upper surface of each of the one or more supports 36 and a lower surface of the substrate 32. The stiffeners 34 may be provided under some or all of the solar energy harvesting device 24 and may provide structural stability, strength, and/or rigidity.

In exemplary embodiments, the solar energy harvesting device 24 may be substantially rectangular in shape, though other shapes are also contemplated. The solar energy harvesting device 24 has a width W₂ that is greater than the width W₁ of the housing 20. Additionally the solar energy harvesting device 24 has a length L₂ that is greater than the length L₁ of the housing 20. The width dimensions W₁, W₂ and the length dimensions L₁, L₂ may be maximum width and length dimensions, respectively, for the solar energy harvesting device 24 and the housing 20, respectively. Stated another way, the solar energy harvesting device 24 has a larger footprint than the footprint of the housing 20. This may provide for increased surface area for collecting solar energy. This may, additionally or alternatively, shade some or all of the housing 20, various components thereof (such as, but not limited to, the electronic display 18), and/or the vehicle 12 when placed in outdoor environments. Such shade may result in better image quality, including, but not limited to, improvised color saturation, contrast, some combination thereof, or the like. This may reduce the brightness levels needed to drive the electronic displays 18, thus resulting in reduced cooling needs. The shade may also decrease the solar loading experienced by the VMDU 10, thus reducing cooling needs.

Those skilled in the art will appreciate that any size, shape, number, type, and orientation of the solar energy harvesting device 24 may be utilized without departing from the scope of the present disclosure. While L1, L2, W1, and W2 may represent maximum dimensions, one or more of L1, L2, W1, and/or W2 may represent minimum dimensions. For example, without limitation, the minimum dimensions of the solar energy harvesting devices 24, W2 and/or L2, may be greater than the maximum dimensions of the housing 20, W1 and/or L1.

The solar energy harvesting device 24 may comprise one or more photovoltaic cells 28. The photovoltaic cells 28 may be mounted to one or more substrates 32. Normally, the photovoltaic cells 28 and/or the substrate 32 may comprise rough edges. A side edge 26 may be provided around an outer edge of the photovoltaic cells 28 and/or the substrate 32. The side edge 26 may provide a smoother surface which is safer for pedestrian interaction and is more aesthetically appealing.

One or more antenna 30 may be provided at the solar energy harvesting device 24. The antenna 30 may be configured to receive and/or transmit radio signals, cellular signals, GPS or other location tracking signals, Bluetooth^{®} or other near field communication signals, some combination thereof, or the like. The antenna(s) 30 may be mounted to the substrate 32, wherein a first antenna 30 may be provided on a front portion of the substrate 32 and a second antenna 30 may be provided on a rear portion of the substrate 32. These antenna(s) 30 may be centered with respect to the side edges of the substrate 32. While any number and position of antenna 30 may be utilized, the configuration of antenna(s) 30 shown may minimize obstructions, thereby improving the transmission and/or receipt of signals.

One or more cameras 44 may be provided at the solar energy harvesting device 24. The cameras 44 may be mounted to the substrate 32. In exemplary embodiments, a first and second camera 44 may be provided on the left and right sides of the substrate 32, respectively, and may be centered from the front to the back (though any number and positioning of the cameras 44 may be utilized). In other exemplary embodiments, the camera 44 may be positioned on a distal end of one or more of the stiffeners 34. Other quantities and positions of the camera(s) 44 may also be utilized without departing from the scope of the present disclosure. In one non-limiting embodiment, the camera(s) 44 may be in electronic communication with the antenna 30 (though such is not required) so that images and/or video may be transmitted to an interested party. In operation, this may be performed for one or more of a variety of different purposes, such as, but not limited to, determining which advertisements and/or public service announcements may be appropriate based on the demographics of the people nearby. Additionally, or alternatively, this data may even be used to turn off the electronic displays 18 remotely.

The solar energy harvesting device 24 may be in electrical connection with various components of the VMDU 10, such as, but not limited to, the electronic displays 18 one or more energy storage devices 38. Additionally, or alternatively, the solar energy harvesting device 24 may be in electrical connection with one or more energy sources 40. The energy storage device 38 may comprise one or more batteries. The energy sources 40 may comprise one or more batteries, alternators, some combination thereof, or the like. In exemplary embodiments, the energy storage device 38 and the energy source 40 may be one and the same, though such is not required.

A controller 42 may be interposed between one or more of: the solar energy harvesting device 24, the VMDU 10, the energy storage device 38, and the energy source 40. The controller 42 may be configured to determine when to draw power from the energy storage device 38 and/or the energy source 40, and when to supply excess energy from the solar energy harvesting device 24 to the energy storage device 38.

While certain components, such as, but not limited to, the energy storage device 38, the energy source 40, and the controller 42 are illustrated as being located outside of the VMDU 10 and the solar energy harvesting device 24, such components may be, partially or entirely, internal to the VMDU 10 and/or the solar energy harvesting device 24. In other words, such components may be placed at any location.

The VMDU 10 may comprise one or more sensors 11 such as, but not limited to, temperature sensors, fan speed sensors, ambient light sensors, accelerometers, some combination thereof, or the like. In this way, the amount of cooling, the brightness of the electronic displays 18, the speed of the fans, some combination thereof, or the like may be adjusted based on ambient temperature, vehicle 12 movement, ambient lighting conditions (including, but not limited to, the amount of shade cast), some combination thereof, or the like. Where wireless connectivity is utilized, data may be collected by these sensors 11 and may be transmitted to one or more remote parties and/or locations where this type of data is desired.

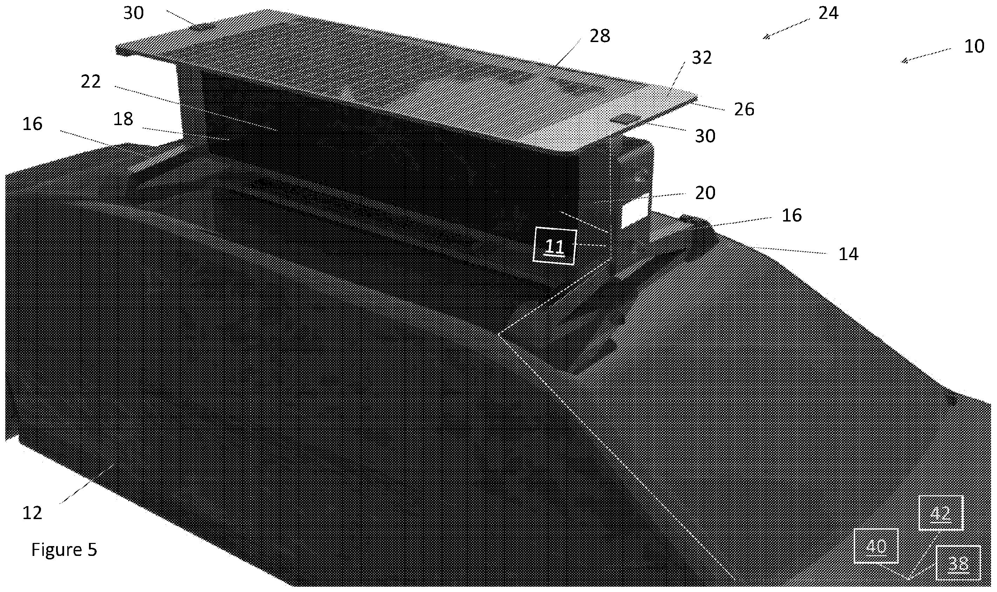

**FIGURE 5** through **FIGURE 7** illustrate another exemplary VMDU 10. The VMDU 10 may have an elongated shape, which may be better suited for particularly long vehicles 12, such as, but not limited to, limousines, buses, RVs, trailers, and/or the like. In such embodiments, an elongated solar energy harvesting device 24 may be provided with multiple supports 36 to ensure that the solar energy harvesting device 24 (which may also be elongated) is adequately supported. In other exemplary embodiments, multiple solar energy harvesting devices 24 may be provided in a substantially linear fashion along the VMDU 10. Those skilled in the art will appreciate, however, that any size, number, and arrangement of electronic display 18 and/or solar energy harvesting devices 24 may be utilized for any size and type of vehicle 12 without departing from the scope of the present disclosure.

The VMDU 10 may be substantially rectangular in shape, though VMDUs 10 of other sizes and/or shapes may also be utilized. Similarly, the solar energy harvesting devices 24 may be provided in any size, shape, orientation (e.g., flush or mounted at an angle), number, type (e.g., opaque, transparent, or translucent panels), composition (e.g., comprising one or more photovoltaic cells) and/or the like. Further, some or all of the solar energy harvesting devices 24 may even be configured to swivel, pivot, tilt, rotate, some combination thereof, and/or the like. Such movement may be accomplished manually or automatically, such as by motor and controller configured to track the sun's movement.

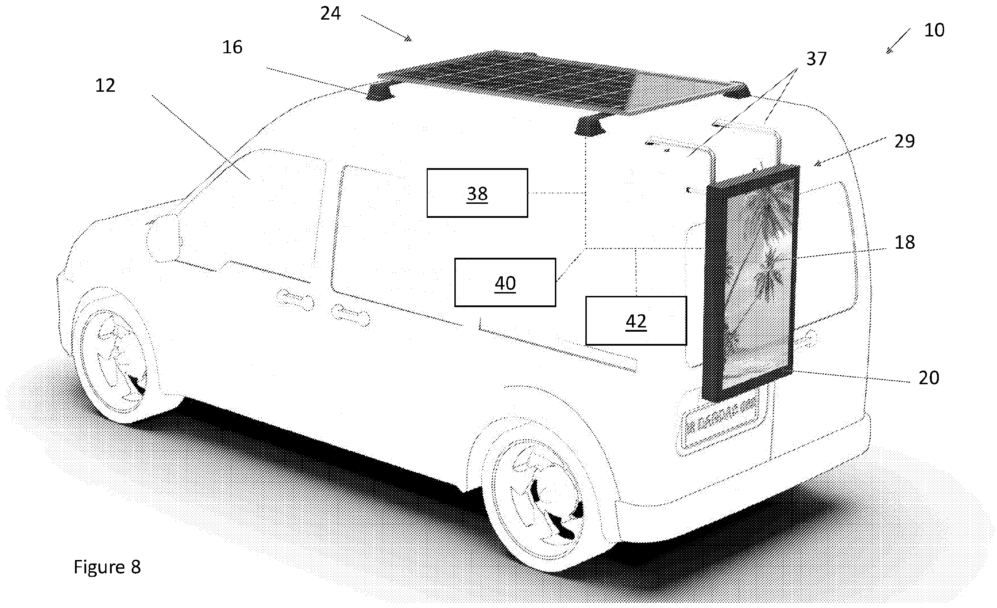

**FIGURE 8** illustrates another exemplary VMDU 10. The VMDU 10 may comprise a display unit 29 which is separate from, but electrically connected to, the solar energy harvesting device(s) 24. The display unit 29 may comprise one or more electronic displays 18 located partially, or entirely, within a housing 20. The housing 20 may be mounted to the vehicle 12. One or more mounting supports 37 may extend from, or within, the housing 20 to a portion of the vehicle 12 and be secured thereto. For example, without limitation, the display unit 29 may be mounted to a rear portion, side portion, front portion, roof, some combination thereof, or the like, of the vehicle 12. Placement of the display unit 29 may be selected to improve visibility, provide multiple displays, and/or improve aerodynamics. More than one display unit 29 may be provided, each of which may be mounted to the same of different portions of the vehicle 12.

In exemplary embodiments, the solar energy harvesting devices 24 may measure approximately 1x2m, though any size, shape, and number of solar energy harvesting devices 24 may be utilized. The solar energy harvesting devices 24 may be mounted to another location of the vehicle 12. In exemplary embodiments, the solar energy harvesting devices 24 are mounted to a roof portion of the vehicle 12, such as, but not limited to, by way of the crossbars 16, however other locations and types of mounting devices may be utilized. For example, without limitation, solar energy harvesting devices 24 may be mounted to a rear portion, side portion, front portion, roof, some combination thereof, or the like, of the vehicle 12. Placement of the solar energy harvesting devices 24 may be selected to improve sunlight exposure, provide multiple solar panels, and/or improve aerodynamics. More than one solar energy harvesting devices 24 may be provided, each of which may be mounted to the same of different portions of the vehicle 12.

An electrical connection, such as by way of wiring, may be provided between the solar energy harvesting devices 24 and one or more components of the display unit 29, such as, but not limited to, the electronic displays 18. Such connections may extend partially or completely within the crossbars 16, other mounting devices, and/or the mounting supports 37. One or more energy storage devices 38, energy sources 40, and/or controllers 42 may be electrically interposed between the solar energy harvesting devices 24 and the display unit 29. In exemplary embodiments, one or more of the energy storage devices 38, energy sources 40, and/or controllers 42 may be provided at the solar energy harvesting devices 24 and/or the display unit 29.

Any number of type of mounting devices, such as, but not limited to, crossbars 16, mounting supports 37, supports 36, members, adhesive, fasteners, welding, ties, some combination thereof, and the like may be utilized to secure the VMDU 10, including, but not limited to, each of the display units 29 and each of the solar energy harvesting devices 24 to various portions of the vehicle 12.

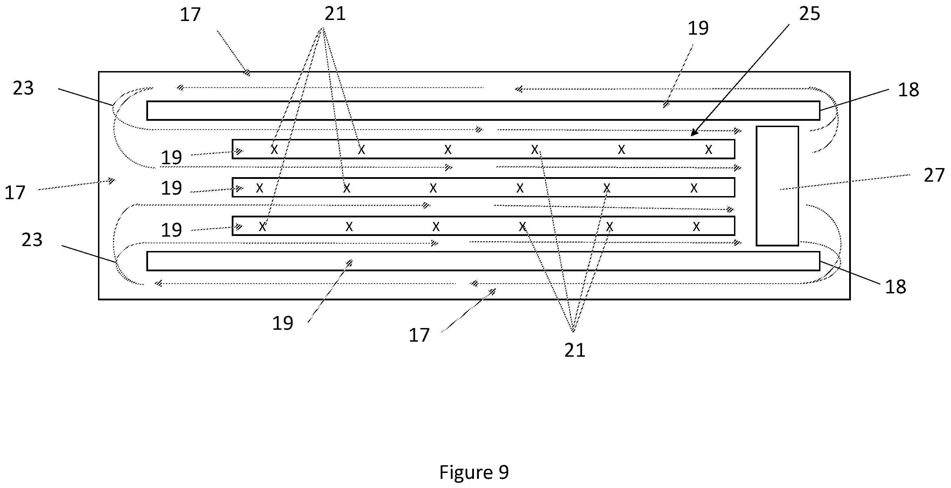

**FIGURE 9** illustrates a top sectional view of an exemplary cooling system for the VMDU 10. The VMDU 10 comprises one or more cooling pathways. Such cooling pathways may comprise openings configured to ingest and exhaust ambient air 21 into and out of one or more open loop pathways 19. In exemplary embodiments, the open loop pathways 19 may pass along backlights for the electronic displays 18. Such cooling pathways may include, additionally or alternatively, closed loop pathways 17 located entirely within the VMDU 10 for circulating gas 23. In exemplary embodiments, the closed loop pathways 17 may encircle the electronic display(s) 18 by passing through a gap between the transparent cover panel and the electronic display 18 of a given side assembly 22. Further, various components may be positioned within either one of the closed loop and the open loop pathways 17, 19. For example, one or more electronic components for operating the VMDU 10 may be provided within or along the closed loop pathways 17. One or more fans may be provided within or along the open loop pathways 19 to force ambient air therethrough. One or more fans 27 may be provided within or along the closed loop pathways 17 to force circulating gas therethrough. A heat exchanger 25 may be provided, preferably behind the electronic display(s) 18, to permit heat transfer between the relatively warm circulating gas 23 in the closed loop pathways 17 and the relatively cool ambient air 21 in the open loop pathways 19.

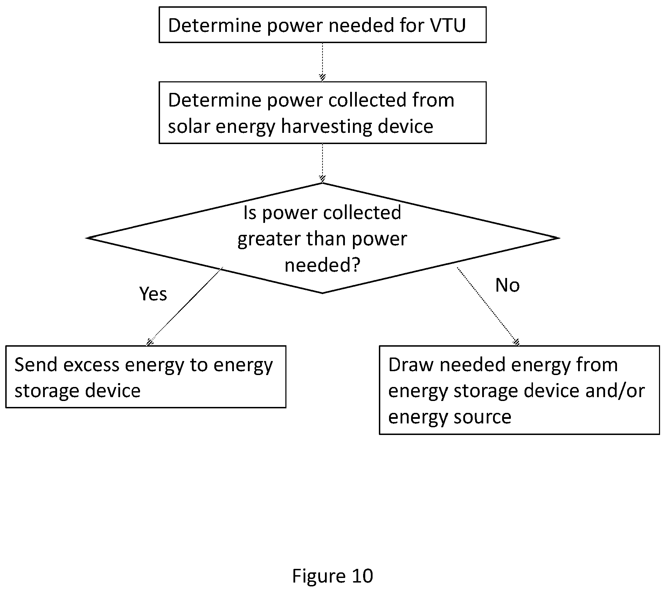

**FIGURE 10** provides a flowchart with exemplary logic for operating the VMDU 10 and related components. The controller 42 may determine the amount of power needed to operate the VMDU 10. This determination may be made, at least in part, based on readings from the sensors 11, operational data from the VMDU 10, historical information, predictions, some combination thereof, or the like. During sufficiently sunny conditions, the controller 42 may be configured to direct power collected from the solar energy harvesting device 24 to the VMDU 10. If excess energy is collected, the controller 42 may be configured to direct such excess power to the one or more energy storage devices 38. If insufficient energy is provided from the solar energy harvesting device 24, such as during nighttime or cloudy conditions, the controller 42 may be configured to direct energy from the one or more energy storage devices 38 and/or the energy sources 40 to VMDU 10. In this way, the VMDU 10 may be periodically, or continuously, powered by the solar energy harvesting device 24. For certain vehicles 12, this may result in improved gas mileage, though such is not required.

The controller 42 may be configured to monitor electrical draw from the VMDU 10. The controller 42 may, alternatively or additionally, be configured to monitor electrical generation from the solar energy harvesting device 24. Electrical draw and production may be monitored in the form of one or more of the following: current, wattage, voltage, some combination thereof, or the like. The controller 42 may, alternatively or additionally, be configured to monitor one or more of the following: ambient lighting conditions (by way of one or more ambient light sensors 11), forecasted weather conditions (by way of network accessible weather data accessed by way of a network connectivity device 15), current or forecasted electrical billing rates (by way of network accessible rate data accessed by way of a network connectivity device 15), user preferences (received by way of the network connectivity device 15), some combination thereof, or the like. In utilizing such information, the controller 42 may be configured to determine which energy source(s) 40 to draw from.

In exemplary embodiments, the electrical systems may be entirely direct current ("DC"). For example, without limitation, the VMDU 10, the solar energy harvesting devices 24, the energy storage devices 38, the energy sources 40, the controller 42, some combination thereof, or the like may be configured to operate solely using DC power. The components and power utilized herein may, in exemplary embodiments without limitation, exclusively utilize direct current power such that no AC-DC or DC-AC inverters or the like are required.

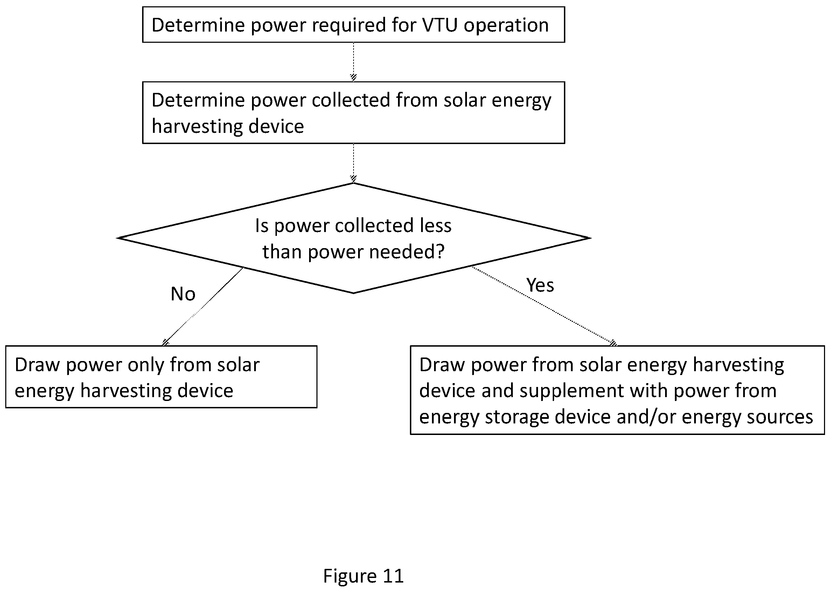

**FIGURE 11** provides a flowchart with exemplary logic for operating the VMDU 10 and related components. The controller 42 may determine the amount of power required to operate the VMDU 10. This determination may be made, at least in part, based on readings from the sensors 11, operational data from the VMDU 10, historical information, predictions, some combination thereof, or the like. During sufficiently sunny conditions, the controller 42 may be configured to direct power collected from the solar energy harvesting device 24 to the VMDU 10. Where sufficient energy is collected, the controller 42 may be configured to power the VMDU 10 only with energy generated by the one or more solar energy harvesting devices 24. Where the power generated by the one or more solar energy harvesting devices 24 is insufficient to power the VMDU 10, the controller 42 may be configured to supplement the power supplied by the one or more solar energy harvesting devices 24 with power from the one or more energy storage devices 38. In this way, power may be drawn from the energy storage devices 38 and/or energy sources 40. Power may be drawn from the energy storage devices 38 and/or energy sources 40 only when needed, and only as much as needed to supplement the power generated by the one or more solar energy harvesting devices 24 to meet the power requirements of the VMDU 10. In this way, the burden on the energy storage devices 38 and/or energy sources 40 may be reduced or eliminated. Furthermore, the VMDU 10 may be periodically, continuously, partially, or wholly powered by the solar energy harvesting device 24. For certain vehicles 12, this may result in improved gas mileage, among other benefits, though such is not required. This may also reduce environmental impact of the VMDU 10.

The controller 42 may be configured to monitor electrical draw and/or needs for the VMDU 10. The controller 42 may, alternatively or additionally, be configured to monitor electrical production from the solar energy harvesting device 24. Electrical draw, needs, and/or production may be monitored by measuring one or more of the following: current, wattage, voltage, some combination thereof, or the like. The controller 42 may, alternatively or additionally, be configured to monitor one or more of the following: ambient lighting conditions (by way of one or more ambient light sensors 11), forecasted weather conditions (by way of network accessible weather data accessed by way of a network connectivity device 15), current or forecasted electrical billing rates (by way of network accessible rate data accessed by way of a network connectivity device 15), user preferences (received by way of the network connectivity device 15), some combination thereof, or the like. The controller 42 may be configured to utilize such information to determine which energy source(s) 40 to utilize.

Operations of the VMDU 10 may be adjusted to raise or lower power requirements of the VMDU 10. For example, without limitation, where the power required for VMDU 10 operations is less than the power generated by the solar energy harvesting device 24, certain operations may be adjusted such as, but not limited to, increasing backlight levels to improve image quality. As another example, without limitation, where the power required for VMDU 10 operations is greater than the power generated by the solar energy harvesting device 24 by a predetermined amount, certain operations may be adjusted, such as, but not limited to, by decreasing backlight levels such that the solar energy harvesting device 24 may fully or more completely power the VMDU 10.

In exemplary embodiments, the electrical systems may be entirely direct current ("DC"). For example, without limitation, the VMDU 10, the solar energy harvesting devices 24, the energy storage devices 38, the energy sources 40, the controller 42, some combination thereof, or the like may be configured to operate using DC power. The components and power utilized herein may, in exemplary embodiments without limitation, exclusively utilize direct current power such that no AC-DC or DC-AC inverters or the like are required.

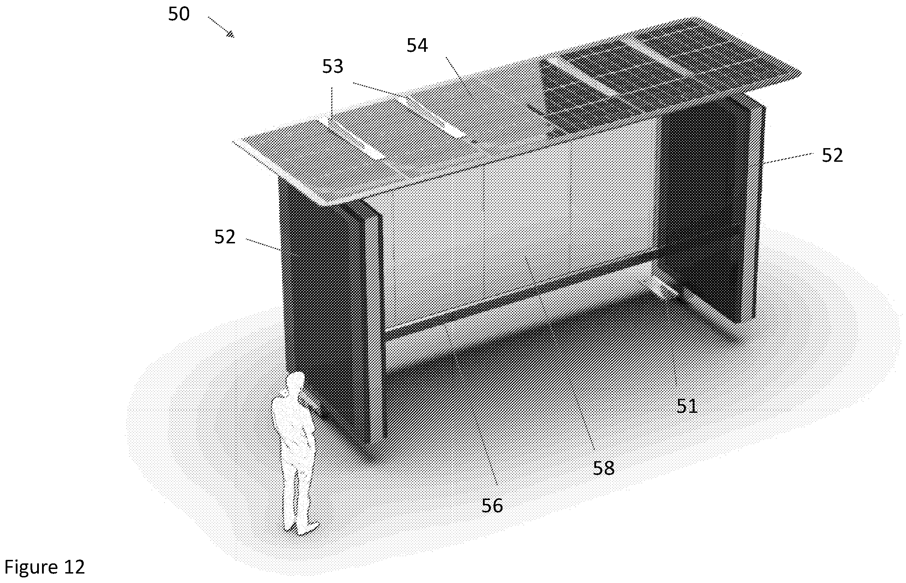

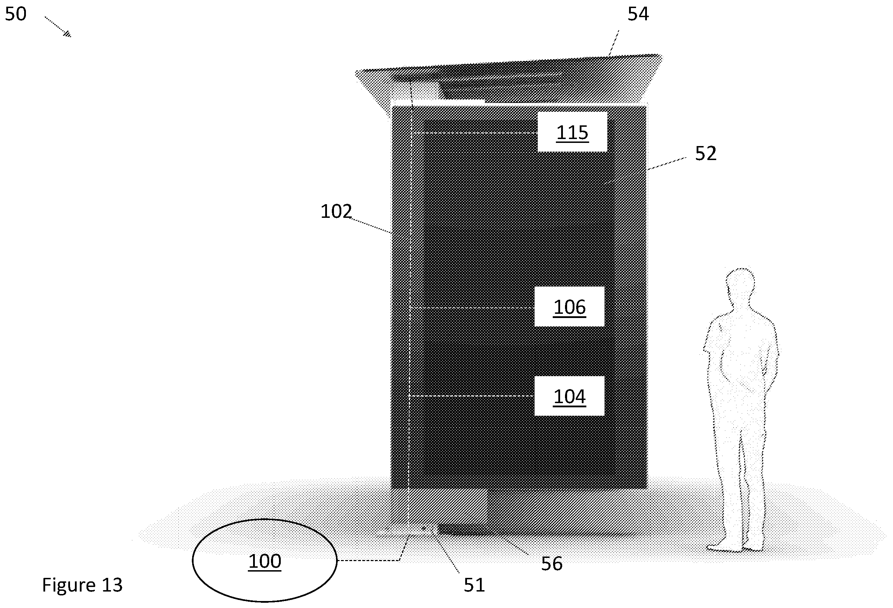

**FIGURE 12** and **FIGURE 13** illustrate exemplary bus shelter assemblies 50. The bus shelter assembly 50 may comprise one or more members 56 forming the structure of the bus shelter assembly 50. One or more feet 51 may be provided for attaching the bus shelter assembly 50 to a sidewalk, the ground, a parking lot, or the like. One or more panels 58 may be located along a rear wall of the bus shelter assembly 50. The panels 28 may be located between at least two of the members 56. The panels 28 may be comprised of an opaque, transparent, or translucent material. Any design, type, or style of bus shelter assembly 50 may be utilized.

The bus shelter assembly 50 may comprise one or more display units 52. The display units 52 may be configured to display, for example, advertisements, public service announcements, and the like. These display units 52 may include displays of any type, size, orientation, and/or shape without departing from the scope of the present disclosure. Further, these display units 52 may be mounted at any suitable location on the bus shelter assembly 50 such as, for example, on either side of the bus shelter assembly 50 and/or to the members 56.

One or more solar energy harvesting devices 54 may be mounted along, or may form, the roof of the bus shelter assembly 50. Where members 56 are provided that form the structure of the roof, the solar energy harvesting device 54 may be mounted onto said members 56. The solar energy harvesting devices 54 may provide shade, rain, and other weather protection for individuals using the bus shelter assembly 50. In exemplary embodiments, the solar energy harvesting devices 54 may extend over one or more of the display units 52 to provide at least partial shade to the display units 52. Though the solar energy harvesting devices 54 may be employed to provide shade, the solar energy harvesting devices 54 may be opaque. However, in other exemplary embodiments, the solar energy harvesting devices 54 may be transparent and/or translucent.

Various roof members 53 may be located between the individual panels of the solar energy harvesting devices 54 to provide structural support and rigidity. As such, it is generally contemplated that said roof members 53 may be of sufficient strength, rigidity, and other material properties so as to provide such structural support and rigidity. In one or more examples, the roof members 53 may be configured to support the solar energy harvesting devices 54 at an angle to improve solar energy gathering.

An electrical pathway 102 may be provided between the solar energy harvesting devices 54 and the display units 52. Through this electrical pathway 102, electrical energy generated by the solar energy harvesting devices 54 may be routed to the display units 52 to power the same. A controller 106 may be located along the electrical pathway 102 and configured to direct the flow of electrical energy, depending on where it is needed. For example, the controller 106 may be configured to direct the display units 52 to utilize electrical energy from the solar energy harvesting devices 54, an electrical grid 100, some combination thereof, and/or the like. Alternatively, or additionally, the controller 106 may be configured to monitor electrical draw from the display units 52 and/or electrical production from the solar energy harvesting device 54. Electrical draw and production may be monitored (e.g., quantified) using any suitable measurement value such as, for example without limitation, micro-watts. In monitoring this information, the controller 106 may be configured to determine which energy source(s) to utilize for one or more components of the bus shelter assembly 50.

One or more sensors 115 may be utilized to detect the power generated by the solar energy harvesting device 54. Data from the sensors 115 may be used by the controller 106 to control operations. The electrical pathway 102, the controller 106, and the sensors 115 may be located internally within the display units 52, one or more of the members 56, the solar energy harvesting device 54, other components of the bus shelter assembly 50, or may be external to the bus shelter assembly 50. The controller 106 may be interposed between the display units 52, the electrical grid 100, and the solar energy harvesting device 54.

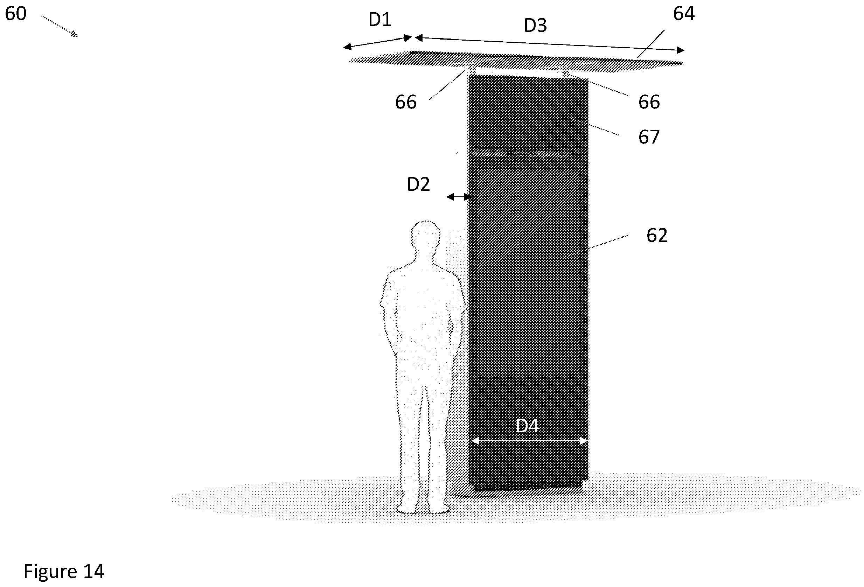

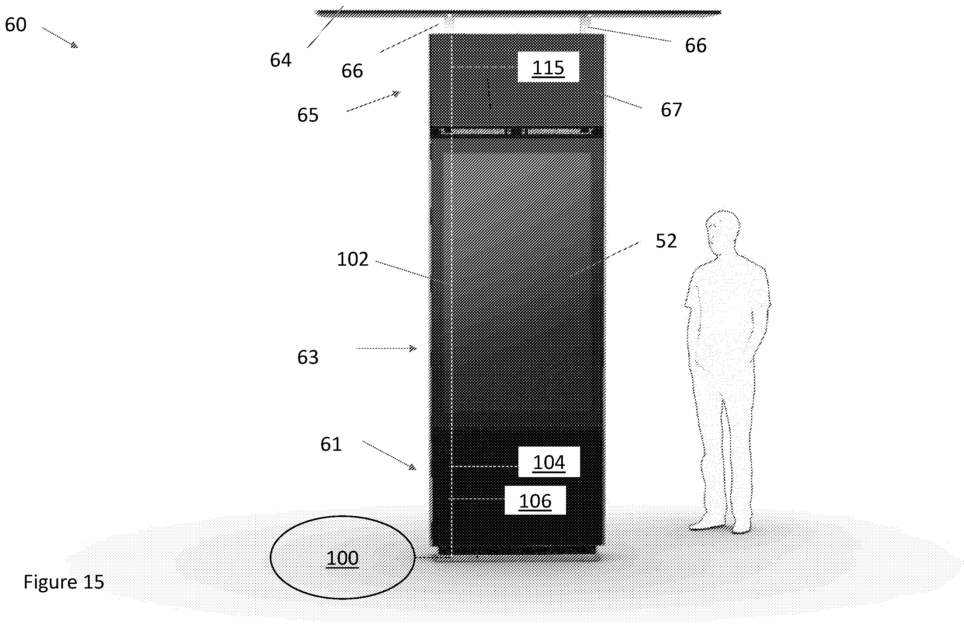

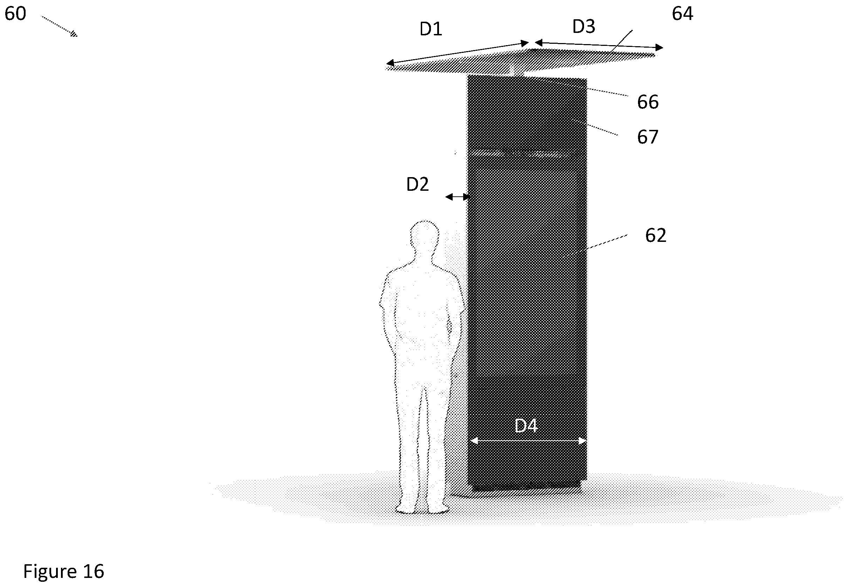

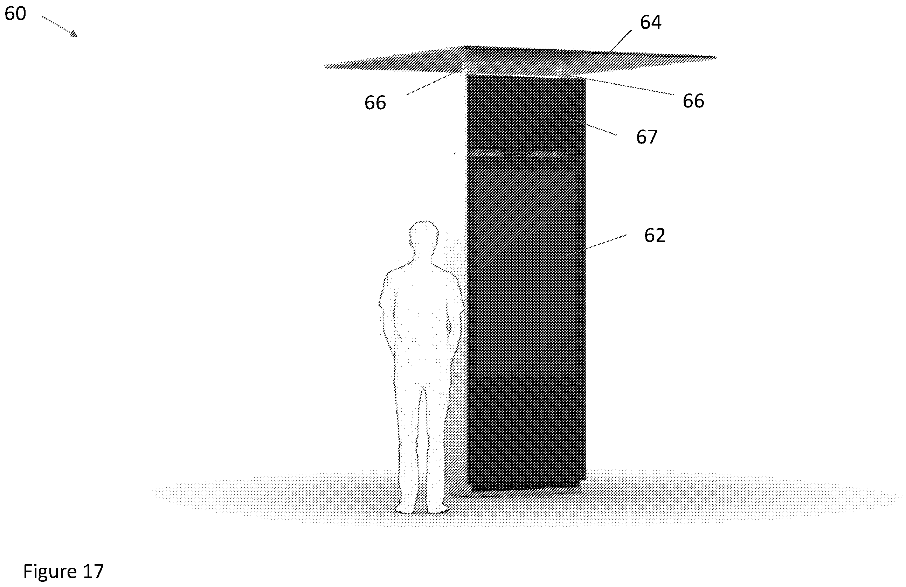

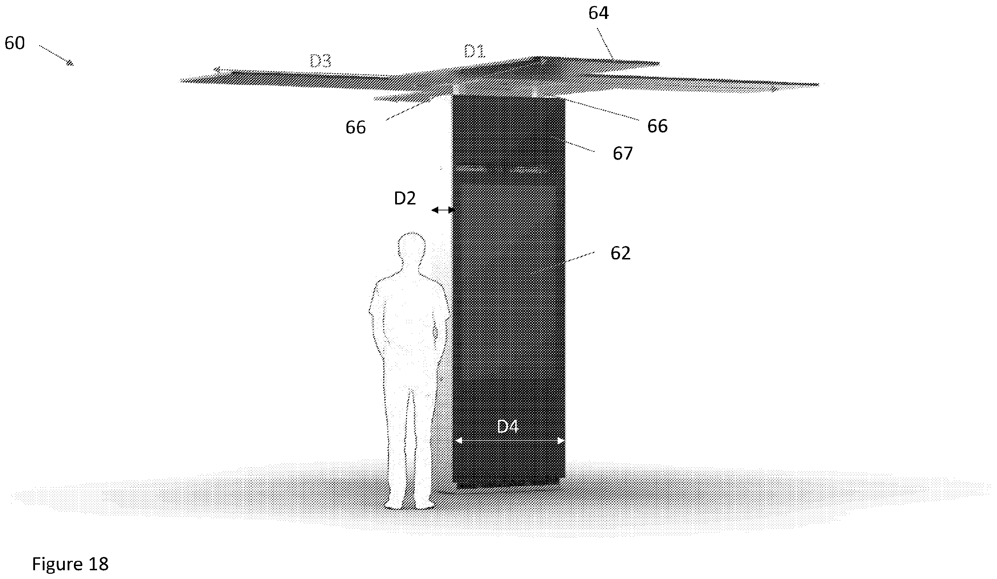

**FIGURE 14** through **FIGURE 18** illustrate exemplary sidewalk assemblies 60. The sidewalk assemblies 60 may be configured for placement in any suitable location, such as sidewalks, parking lots, and/or other public places, and may be mounted to the ground, a sidewalk, a parking lot, a wall, a building, or another structure or surface. Each surface mounted assembly 60 may include one or more display units 62, support members 66, and solar energy harvesting devices 64. Further, each display unit 64 may include one or more electronic displays.

Sidewalk assemblies 60 having more than one display unit 62 may position said display units 62 in any suitable arrangement. For example, without limitation, a single, double, triple, or quadruple sided set of display units 62 may be provided in a given surface mounted assembly 60. Similarly, the electronic displays within each display unit 62 may also be positioned in any suitable arrangement. Any number, size, arrangement, and type of electronic displays may be utilized. Further, each electronic display may be provided in the same or a separate display unit 62, which may be physically connected to one another such as in a triangular or rectangular shape.

One or more support members 66 may extend above the display units 62 to one or more solar energy harvesting devices 64. Practically speaking, the support member(s) 66 support the weight the solar energy harvesting devices 64 and, as such, should generally comprise the strength and rigidity required to do so. The support members 66 may be assembled in any suitable arrangement. For example, the support member 66 may extend from an upper surface of a housing 67. In another example, the support members 66 may be anchored within the display units 62 or other components of the surface mounted assembly 60.

The one or more solar energy harvesting devices 64 may have a maximum first dimension D1 which extends beyond the maximum second dimension D2 of the surface mounted assembly 60. The dimensions D1 and D2 may be depth of the solar energy harvesting devices 64 and the surface mounted assembly 60, respectively. Alternatively, or additionally, the one or more solar energy harvesting devices 64 may have a maximum third dimension D3 which extends beyond the maximum fourth dimension D4 of the surface mounted assembly 60. The dimensions D3 and D4 may be width of the solar energy harvesting devices 64 and the surface mounted assembly 60, respectively. Stated another way, the solar energy harvesting devices 64 may have a footprint which extends beyond the footprint of the surface mounted assembly 60. In this way, the solar energy harvesting devices 64 may shade some or all of the display units 62 of the surface mounted assembly 60. While D1, D2, D3, and D4 may represent maximum dimensions, one or more of D1, D2, D3, and/or D4 may represent minimum dimensions. For example, without limitation, the minimum dimensions of the solar energy harvesting devices 64, D1 and/or D3, may be greater than the maximum dimensions of the surface mounted assembly 60, D2 and D4. For example, without limitation, the footprint of the solar energy harvesting device 64 may be at least twice as large as the footprint of the display assembly 60. The solar energy harvesting device 64 may positioned directly above the display assembly 60. The footprint of the solar energy harvesting device 64 may overlie the footprint of the display assembly 60.

The solar energy harvesting devices 64 may extend laterally. Stated another way, the solar energy harvesting devices 64 may extend along the width of the display units 62. Stated yet another way, the solar energy harvesting devices 64 may extend from left to right or right to left when viewed from the front or rear. Alternatively, or additionally, the solar energy harvesting devices 64 may be oriented to extend towards or away from an intended viewer of the display units 62 when viewed from the front or rear. Stated another way, the solar energy harvesting devices 64 may extend along the depth of the display units 62 when viewed from the front or rear. Stated yet another way, the solar energy harvesting devices 64 may extend into or out of the page when viewed from the front or rear of the surface mounted assembly 60.

Any number of solar energy harvesting devices 64 may be provided in any orientation. For example, without limitation, two of the solar energy harvesting devices 64 may be provided to extend in parallel to one another. As another example, without limitation, the solar energy harvesting devices 64 may extend both laterally and towards and way from an intended viewer of the display units 62. As yet another example, without limitation, multiple solar energy harvesting devices 64 may be provided in a fanned array such that some of the solar energy harvesting devices 64 extend in different directions compared to other solar energy harvesting devices 64 for the surface mounted assembly 60. Other orientations may be employed without departing from the scope of the present disclosure.

In exemplary embodiments, the sidewalk assemblies 60 may each comprise an upper portion 65, an electronic display layer portion 63, and a lower portion 61. In exemplary embodiments, the controller 106 may be located in the lower portion 61. In other exemplary embodiments, the controller 106, may be located in electronic display layer portion 63, such as, but not limited to, within a sealed plenum between a front facing and rear facing electronic display layer. Such components may be protected from flooding and/or contaminates in the ambient air. In yet another example, the upper portion 65 may be comprised of material configured to permit radio and/or other signals to enter and exiting the upper portion 65. Communication equipment may be placed in the upper portion 65 to further increase the ability to transmit and receive signals. The electrical pathway 102 may extend through one or more of the support members 66 to place in electrical communication one or more components of the surface mounted assembly 60, regardless of which portion 61, 63, 65 they are located in. Accordingly, in one or more examples, the support member 66 may be hollow to accommodate the necessary wiring. Those skilled in the art will appreciate that other locations and configurations for such components may be utilized without departing from the scope of the present disclosure.

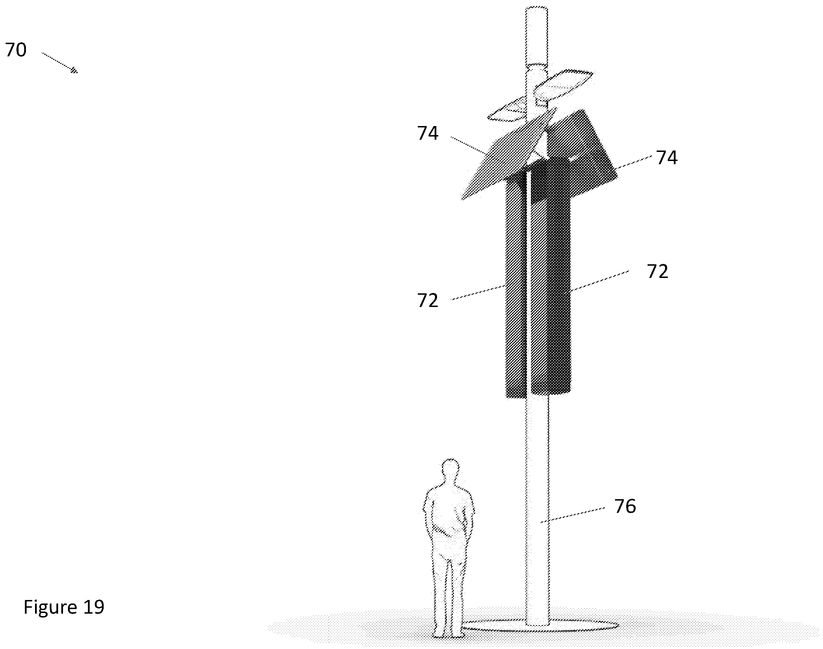

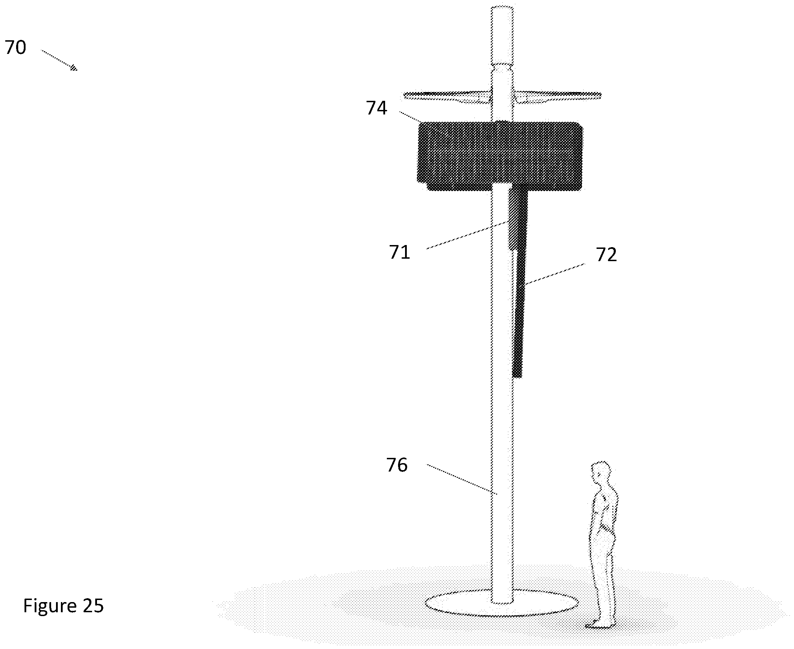

**FIGURE 19** though **FIGURE 25** illustrate exemplary pole mounted assemblies 70. The pole mount assemblies 70 may each comprise a pole 76, one or more display units 72, and one or more solar energy harvesting devices 74.

The pole 76 may comprise any shape, and may be mounted in any location. For example, without limitation, the pole 76 may be mounted to the ground, a sidewalk, a building, or other structure or surface. The pole 76 may comprise a circular, triangular, rectangular, square, hexagonal, octagonal cross-section, some combination thereof, and/or the like. The pole 76 may comprise a pre-existing pole, having a pre-existing function, that was simply adapted into a pole mounted assembly. The pole 76 may comprise a light pole, a flag pole, a support pole, a column, some combination thereof, and/or the like.

One or more display units 72 may be mounted to the pole 76 in any orientation. For example, without limitation, one, two, three, or four display units 72 may be mounted to the pole 76, and may be evenly spaced around the pole 76, though such is not required. These display units 72 may be similar or different in size and/or shape (e.g., substantially cuboid in shape and/or comprising rounded edges). In exemplary embodiments, the display units 72 may be mounted to the pole 76 in a flag orientation wherein a side surface of the housing for the display units 72 is mounted to the pole 76. If more than one display units 72 are to be mounted, such display units 72 may be mounted parallel to one another on opposing sides of the pole 76. One or more of the display units 72 may, alternatively, or additionally, be flush mounted to the pole 76 wherein a rear surface of the housing for the display units 72 may be mounted to the pole 76. Where more than one display unit 72 is mounted to the pole 76, such display units 72 may be in a back-to-back arrangement on opposing sides of the pole 76. Combinations of flush mounted display units 72 and flag mounted display units 72 may be utilized on a given pole 76. A mounting fixture 71 may extend from each of the display units 72 to the pole 76. In exemplary embodiments, the mounting fixture 71 may be attached to the housing for the display units 72. Alternatively, or additionally, the mounting fixture 71 may be attached to internal structural components of the display units 72 and may extend through the housing for the display units 72. At least one surface of the mounting fixture 71 may be configured to substantially match the shape of the pole 76. For example, without limitation, the mounting fixture 71 may comprise a plate for mounting to a pole 76 having a flat outer surface for mounting to the display unit 72 and a curved inner surface for mounting to a curved pole 76.

The mounting fixture 71 may comprise a collar 77B configured to wrap around some or all of the outer surface of the pole 76. The mounting fixture 71 may, alternatively, or additionally, comprise members, fasteners, nuts, receivers, bolts, screws, nails, adhesive, weld material, straps, some combination thereof, or the like. Attachment of the display units 72 to the pole 76 may be performed by wrapping straps around the pole 76, drilling holes in the pole 76, fastening, bolting, screwing, nailing, welding, bonding, or otherwise attaching the display units 72 to the pole 76. Any type, shape, or size mounting fixture 71 may be utilized. Any type of attachment technique may be utilized.

The display units 72 may comprise one or more peripheral devices 79. Such peripheral devices 79 may include, but is not limited to, network connectivity devices, power modules, microphones, cameras, antenna, ambient light sensors, ambient temperature sensors, air quality monitors, some combination thereof, and/or the like. Such peripheral devices 79 may be provided in a dome, a protrusion, or other structure along an upper, lower, or side surface of the housing for the display units 72.

One or more solar energy harvesting devices 74 may be mounted to the pole 76. Such solar energy harvesting devices 74 may be mounted above the display units 72, though such solar energy harvesting devices 74 may be mounted at any location. In exemplary embodiments, the solar energy harvesting devices 74 may extend at an angle from the pole 76. The solar energy harvesting devices 74 may extend perpendicular to the ground. The support structures 78 may comprise one or more collars 77A, 77B which wrap around the pole 76.

The solar energy harvesting devices 74 may extend from the same or a different side of the pole 76 as the display units 72. An upper and lower edge of the solar energy harvesting devices 74 may extend parallel with an upper and lower edge of the display units 72, though such is not required. The solar energy harvesting devices 74 may be oriented on the pole 76 to cast shade of the display units 72 during some or all of the day.

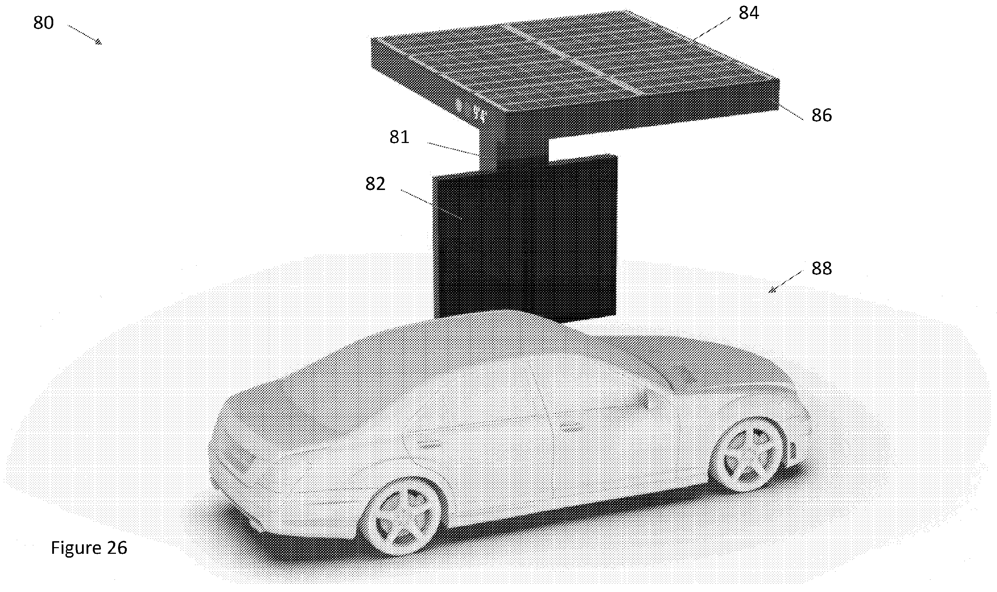

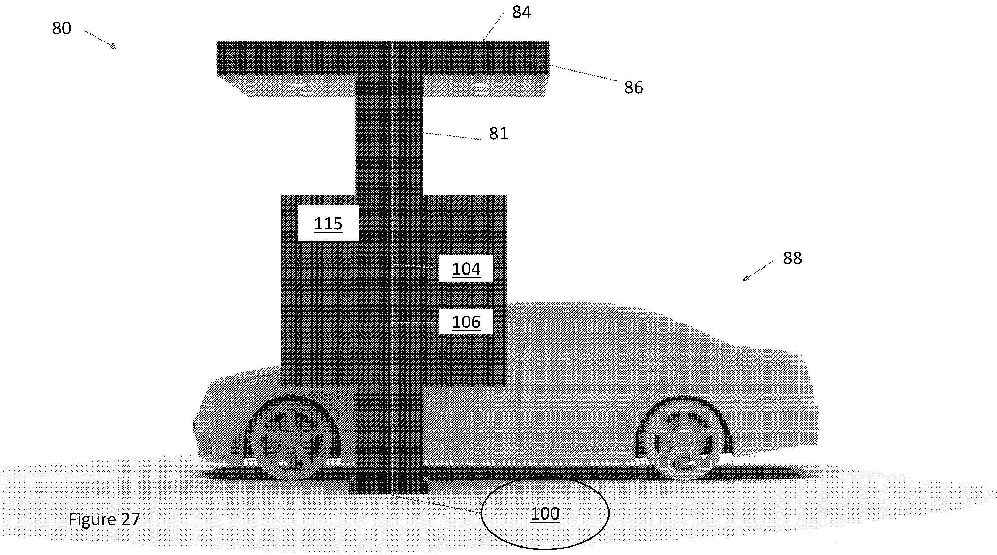

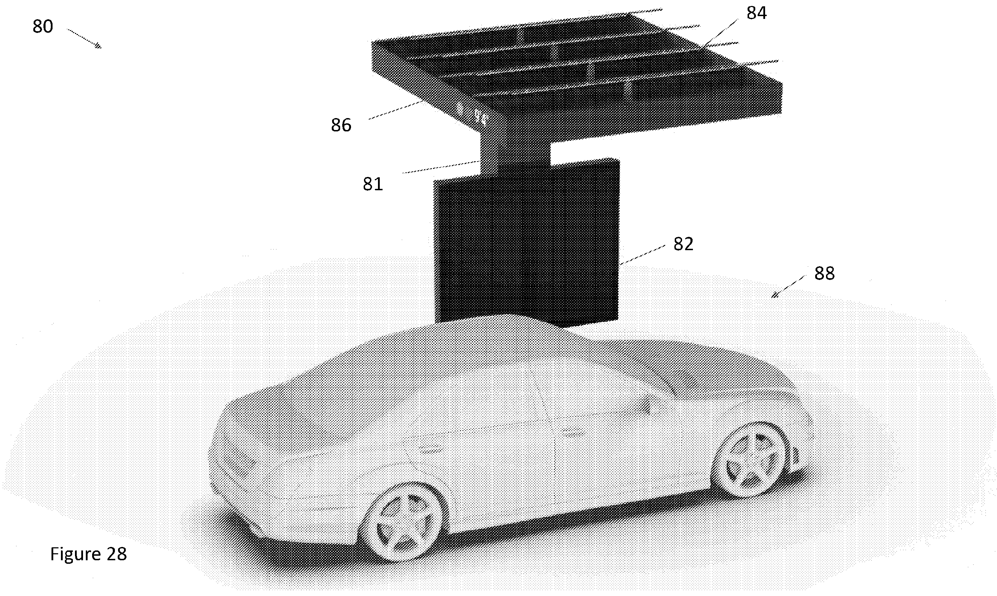

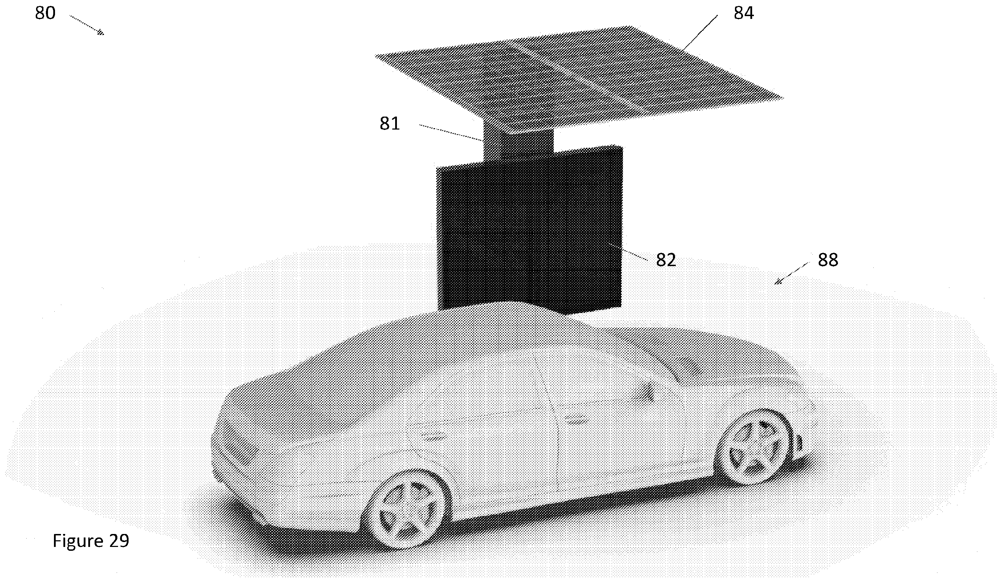

**FIGURE 26** through **FIGURE 29** illustrate exemplary canopy assemblies 80. Canopies 86 of any size or style may be utilized, though it is generally contemplated that canopies 86 may preferably be sized and shaped to extend (e.g., horizontally) over some or all of a vehicle 88 located adjected to the canopy assembly 80. In this way, the canopy 86 may provide shade to some or all of the display units, as well as to some or all of the vehicle 88, thereby also preventing rain from entering the vehicle 88 when a window of the vehicle is rolled down.

The canopy assemblies 80 may include a vertically extending member 81 which extends from the ground to a position along the canopy 86 (or the solar energy harvesting devices 84, discussed below) where the vertically extending member 81 may securely support the size and weight of the canopy 86 and/or the solar energy harvesting devices 84 (e.g., relatively near the center instead of the periphery of the canopy). Accordingly, it is generally contemplated that the vertically extending member 81 may comprise the necessary strength and/or rigidity required to do so.

One or more display units 82 may be mounted to the canopy assembly 80 or otherwise provided nearby, and may differ in terms of size, arrangement, and composition. In exemplary embodiments, the display units 82 may be mounted to the vertical member 81. The display units 82 may be configured to provide digital menu boards. One or more solar energy harvesting devices 84 may be mounted to the upper portion of the canopy assembly 80. Such solar energy harvesting devices 84 may be mounted flush with an upper surface of the canopy assembly 80. Such solar energy harvesting devices 84 may be mounted at an angle to the upper surface of the canopy assembly 80.

The solar energy harvesting device(s) 84 may be provided either additionally or alternatively to the canopy 86, and may be transparent or translucent. If provided in addition, the solar energy harvesting device(s) 84 may be mounted on top of the canopy 86, or elsewhere. Any suitable orientation may be employed, such as where the solar energy harvesting devices 84 are flush with an upper surface of the canopy assembly 80 and/or where the solar energy harvesting devices 84 are mounted at an angle to the upper surface of the canopy assembly 80. Other orientations and/or combinations of orientations are also contemplated.

Any of the display units 52, 62, 72, 82, may be single sided, double sided, and/or the like. In another example, each of the display units 52, 62, 72, 82 may comprise liquid crystal displays, plasma displays, organic light emitting diode displays, light emitting diode displays, rear projection displays, cathode ray display, some combination thereof, and/or the like. The electronic display(s) within the display units 52, 62, 72, 82 may be provided in any number, size, shape, type, orientation (e.g., landscape or portrait), and/or the like without departing from the scope of the present disclosure. Further, such display units 52, 62, 72, 82 may comprise backlights, such as, but not limited to, direct backlights, edge lights, some combination thereof, or the like. Alternatively, or additionally, such display units 52, 62, 72, 82 may also comprise emissive displays. As configured, said display units 52, 62, 72, 82 may be programmed to display any type of information/image/video. In yet another example, each of the display units 52, 62, 72, 82 may, alternatively, or additionally, include poster holders that may include a compartment configured to accommodate signage such as posters, artwork, signage, changeable letter boards, some combination thereof, and/or the like. The compartment may be defined between a transparent cover panel and the electronic display (and/or a poster) within a display unit housing. The poster holders may further include an illumination device for illuminating the signage deposited therein.

The display units 52, 62, 72, 82 may be substantially rectangular in shape, though any size and shape may be utilized. The display units 52, 62, 72, 82 may comprise one or more cooling pathways. Such cooling pathways may comprise openings configured to ingest and exhaust ambient air and move such ambient air though open loop pathways. In exemplary embodiments, such open loop pathways may extend along backlights for the display units 52, 62, 72, 82. Such cooling pathways may include, additionally, or alternatively, closed loop pathways located entirely within the display units 52, 62, 72, 82 for circulating gas. In exemplary embodiments, the closed loop pathways may encircle the electronic displays of the display units 52, 62, 72, 82 by passing the circulating gas through a gap between the transparent cover panel and the electronic display surface. One or more electronic components for operating the display units 52, 62, 72, 82 may be provided within, along, or adjacent to the closed loop pathways. Such electronic components may comprise the peripheral devices 79, video players, power supplies, controllers, network connectivity devices, antenna, computers, some combination thereof, or the like. One or more fans may be provided within or along the open loop pathways to force ambient air therethrough. One or more fans may be provided within or along the closed loop pathways to force circulating gas therethrough. A heat exchanger may be provided, preferably behind one or more of the display units 52, 62, 72, 82 to permit heat transfer between the relatively warm circulating gas in the closed loop pathway and the relatively cool ambient air in the open loop pathway.

Any of the solar energy harvesting devices 24, 54, 64, 74, and 84 may utilize opaque, transparent, and/or translucent panels, and may be provided in any size, shape, orientation (e.g., flush or mounted at an angle), number, type, and/or the like. These solar energy harvesting devices 24, 54, 64, 74, and 84 may comprise any number of photovoltaic cells. Some or all of the solar energy harvesting devices 24, 54, 64, 74, and 84 may be configured to swivel, pivot, tilt, rotate, some combination thereof, or the like. Such movement may be accomplished manually or automatically, such as by motor and controller configured to track the sun's movement.

While the solar energy harvesting devices 24, 54, 64, 74, and 84 may be shown or described herein as being mounted on, or otherwise associated with, various structures, such as, but not limited to, the bus shelter assembly 50, the surface mounted assembly 60, the pole mounted assemblies 70, and the canopy assemblies 80, some or all of such solar energy harvesting devices 24, 54, 64, 74, and 84 may, alternatively, or additionally, be positioned elsewhere such as, without limitation, on the adjacent ground, on a nearby structure (e.g., roof or pole), some combination thereof, or the like. This may permit improved position for efficient collection of solar energy as well as the ability to use an expanded surface area for powering the units.

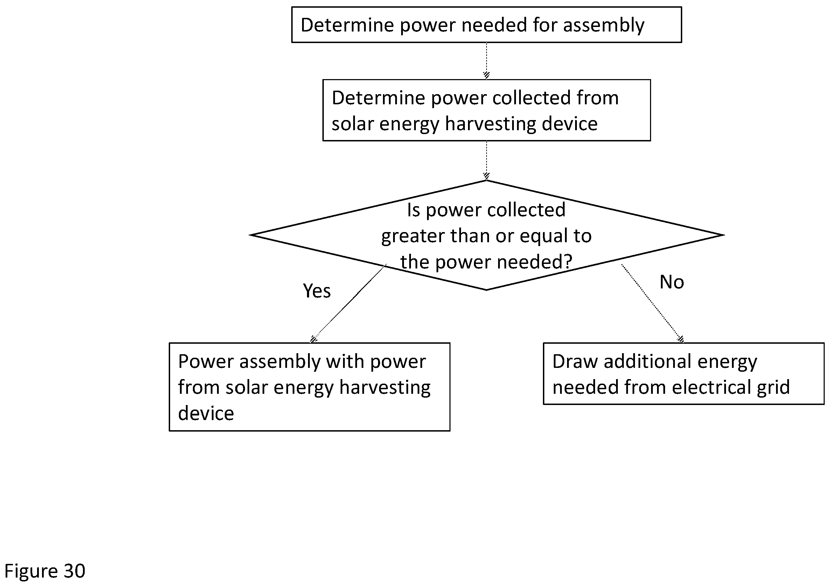

**FIGURE 30** provides a flowchart with exemplary logic for operating the various assemblies 50, 60, 70, 80 and related components. The controller 106 may determine the amount of power needed to operate the assembly 50, 60, 70, 80. This determination may be performed by the controller 106 and may be based, at least in part, on readings from the sensors 115, operational data from the assemblies 50, 60, 70, 80, historical information, predictions, some combination thereof, or the like. The amount of electrical energy collected by the solar energy harvesting device 54, 64, 74, 84 may be determined. The solar energy harvesting devices 54, 64, 74, 84 may be located at least 9.5 ft. above the ground surface, though any height may be utilized. The controller 106 may be configured to determine if the energy collected is greater than or equal to the power needed. If yes, the controller 106 may be configured to power the assembly 50, 60, 70, 80 only with the power collected by the solar energy harvesting device 54, 64, 74, 84. If no, the controller 106 may be configured to draw all available energy from the solar energy harvesting devices 54, 64, 74, 84 and draw supplemental power from the electrical grid 100 sufficient to power the assembly 50, 60, 70, 80.

In one non-limiting example, power generated by the solar energy harvesting devices 54, 64, 74, 84 may be used to power the display units 52, 62, 72, 82 when conditions are sufficiently sunny. In this example, the power generated by the solar energy harvesting devices 54, 64, 74, 84 may be greater than or equal to the power needed to operate the assembly. If there is excess energy, that energy may be transmitted back into the electrical grid 100.

In another non-limiting example, the power generated by the solar energy harvesting devices 54, 64, 74, 84 may be insufficient to operate the display units 52, 62, 72, 82. This may occur, for example, when the solar energy harvesting devices is not receiving enough solar energy (e.g., too cloudy, obstructions blocking sunlight, debris on the solar energy harvesting devices, etc.). In which case, the assemblies 50, 60, 70, 80 may draw energy from the electrical grid 100, but preferably only to the extent it is needed to compensate for the insufficient amount of energy generated by the solar energy harvesting devices 54, 64, 74, 84.

For example, without limitation, power generated by the solar energy harvesting devices 54, 64, 74, 84 may be used to power the display units 52, 62, 72, 82 when conditions are sufficiently sunny. Excess energy, if any, may be transmitted back into the electrical grid 100, though such is not required.

The use of energy collected by the solar energy harvesting devices 54, 64, 74, 84 may reduce the environmental impact of the assemblies 50, 60, 70, 80 by reducing the degree to which said assemblies rely on the electrical grid 100. The use of such solar energy harvesting devices 54, 64, 74, 84 may serve as a more environmentally sustainable, alternative energy source. The display units 52, 62, 72, 82 may be periodically, or continuously, powered by the solar energy harvesting device 54, 64, 74, 84. Alternatively, or additionally, the assemblies 50, 60, 70, 80 may generate revenue by placing electricity back into the electrical grid 100.

Bulk energy storage devices 104, such as batteries, super capacitors, ultra-capacitors, and the like, are commonly used to store energy. The solar energy harvesting devices 54, 64, 74, 84 may store energy in the bulk energy storage devices 104 when the solar energy harvesting devices 54, 64, 74, 84 are generating a surplus of energy (e.g., such as when it is sunny). Then, when the energy generated by the solar energy harvesting devices 54, 64, 74, 84 starts to diminish (e.g., such as when it is dark), stored energy within the bulk energy storage devices 104 may be used to provide power.

In exemplary embodiments of the assemblies, however, no bulk energy storage devices 104 are used. Such bulk energy devices 104 can be seen as a liability as they, for example, without limitation, may comprise flammable materials, may require rare earth materials, may take up physical space within the assembly, may require periodic replacement, to name a few examples, without limitation. Because the assemblies 50, 60, 70, 80 of the present disclosure are capable of drawing supplemental energy from the electrical grid 100, in exemplary embodiments, such bulk energy storage devices 104 are not required.

In exemplary embodiments, no AC-DC converters are required. For example, without limitation, the display units 52, 62, 72, 82 may be configured to directly accept both AC and DC power, though such is not required. In exemplary embodiments, the display units 52, 62, 72, 82 may be configured to directly accept DC power generated by the solar energy harvesting devices 54, 64, 74, 84, and the display units 52, 62, 72, 82 may be configured to directly accept AC power generated by the electrical grid 100. Inverters may be provided where required to convert between AC and DC power.

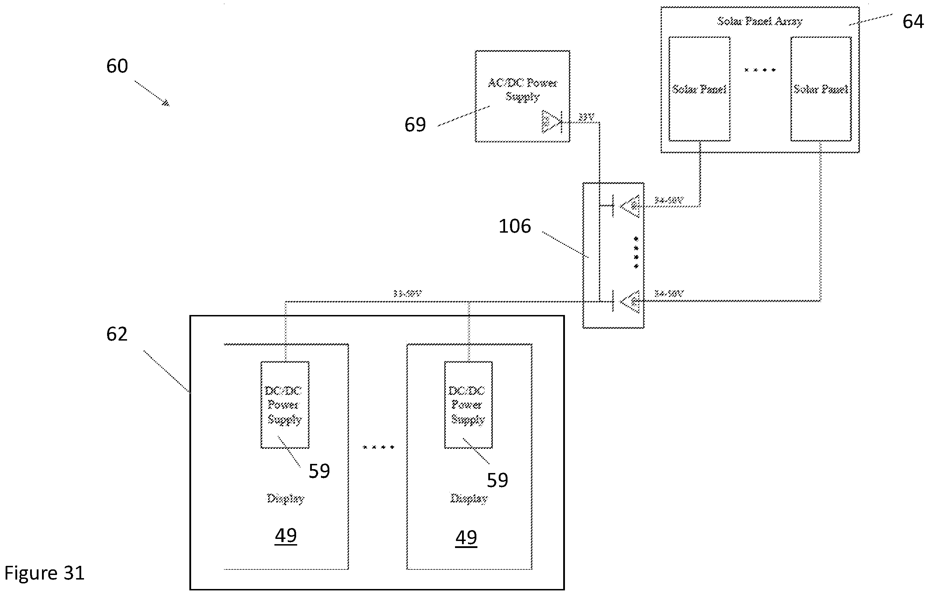

**FIGURE 31** illustrates a schematic illustration of an exemplary embodiment of an assembly 60. The assembly 60 may comprise a solar panel array 64 having two or more solar panels. The assembly 60 may comprise two or more electronic displays 49. The assembly 60 may comprise a DC/DC power supply 59 for each electronic display 49. The assembly 50 may comprise an AC/DC power supply 69. A controller 106 may be placed in electronic communication with the AC/DC power supply 69, the solar panel array 64, and the display unit 62. The AC/DC power supply 69 in exemplary embodiments, without limitation, may comprise the electrical grid 100. In operation, the solar panel array may supply power to the controller 106 (e.g., 34-50 volts) via a perfect diode (or an ideal diode). The controller 106 may then direct this power to the AC/DC power supply (e.g., 33 volts) via another perfect diode, and/or also to the DC/DC power supplies within the displays (e.g., 33-50 volts).

While certain references are made herein with regards to the assembly 60 and display unit 62, the same or similar arrangement may be utilized with regard to the various assemblies 50, 60, 70, 80 and related components

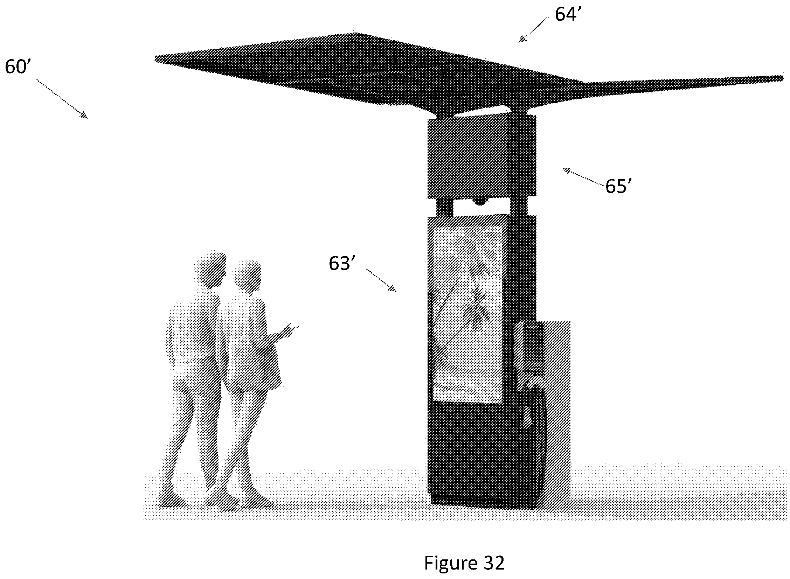

**FIGURE 32** illustrates another exemplary surface mounted assembly 60'. The surface mounted assembly 60' may be similar to, and/or may comprise some or all of the same components as the surface mounted assembly 60. The surface mounted assembly 60' may comprise one or more solar energy harvesting devices 64'. The solar energy harvesting devices 64' may be the same, or similar to, the solar energy harvesting devices 64 previously shown and/or described herein. In exemplary embodiments, the solar energy harvesting devices 64' may comprise multiple solar panels mounted at an angle to one another, such as but not limited forming a "V" shape. The surface mounted assembly 60' may comprise an upper portion 65' which may be the same or similar to the upper portion 65, though such is not required. The surface mounted assembly 60' may comprise a display layer portion 63' which may be the same or similar to the display layer portion 63, though such is not required.

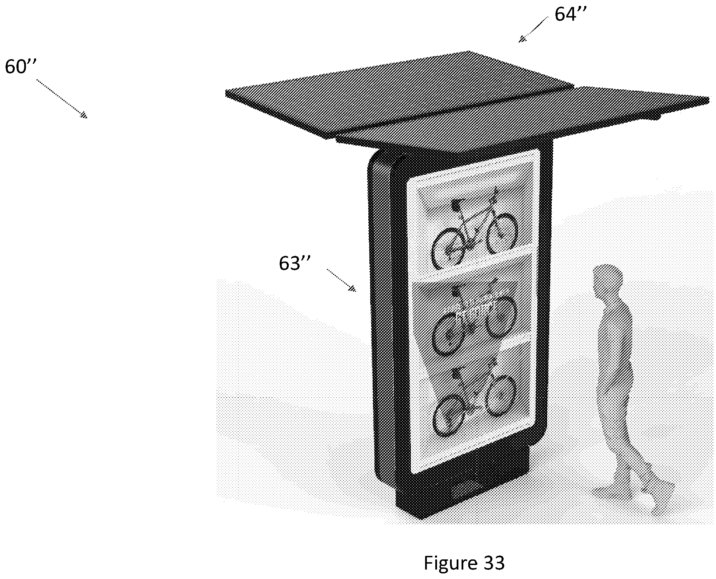

**FIGURE 33** illustrates another exemplary surface mounted assembly 60". The surface mounted assembly 60" may be similar to, and/or may comprise some or all of the same components as the surface mounted assembly 60 and/or 60'. The surface mounted assembly 60" may comprise one or more solar energy harvesting devices 64". The solar energy harvesting devices 64" may be the same, or similar to, the solar energy harvesting devices 64 and/or 64' previously shown and/or described herein. In exemplary embodiments, the solar energy harvesting devices 64" may comprise multiple solar panels mounted at an angle to one another, such as but not limited forming a "V" shape. The surface mounted assembly 60" may comprise a display layer portion 63" which may be the same or similar to the display layer portion 63, though such is not required.

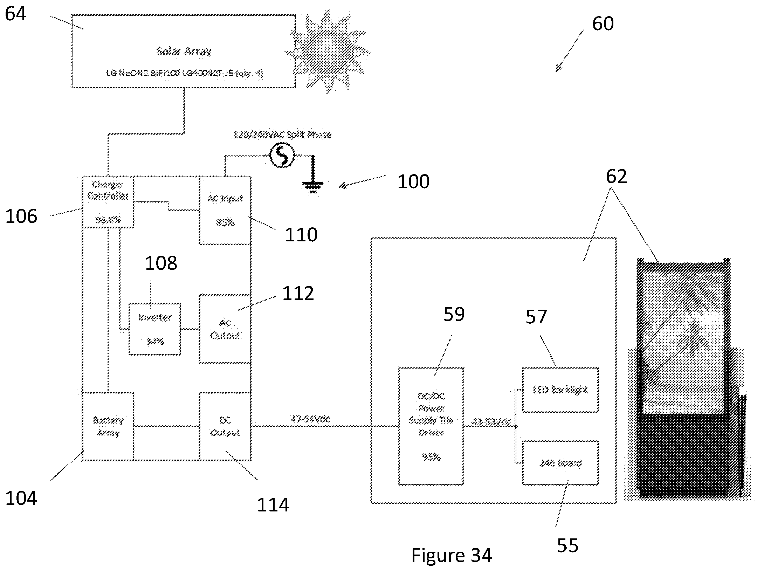

**FIGURE 34** is an exemplary electrical schematic. The solar energy harvesting devices 64 may be placed in electrical connection with the controller 106. The controller 106 may be in electrical connection with the utility power supply 100, such as, but not limited to, by way of an AC input 110. An inverter 108 may be electrically interposed between the AC input 110 and an AC output 112 to convert AC power to DC power as required. The controller 106 may be electrically connected to one or more energy storage devices 104 for storing excess energy and disbursing such excess energy as instructed by the controller 106. The energy storage devices 104 may be in electrical connection with an DC output 114.

The DC output 114 may be placed in electrical connection with one or more display units 62. The DC power may be received at a DC/DC power supply 59. The DC/DC power supply 59 may distribute DC power to backlights 57 and/or various electrical components 55 of the display unit 62, the display layer portion 63, and/or other various components of the assembly 60 such as, but not limited to, sensors, fans, cooling devices, customer equipment, electronics, any combination thereof, or the like.

While certain references are made herein with regards to the assembly 60 and display unit 62, the same or similar arrangement may be utilized with regard to the various assemblies 50, 60, 60', 60", 70, 80 and related components.

Exemplary electrical efficiencies are provided at figure 34 by way of non-limiting example to demonstrate the increase in efficiency realized by utilizing a DC/DC system. Such efficiencies may be based on simulated weather conditions based on historical weather and other environmental considerations for a given location.

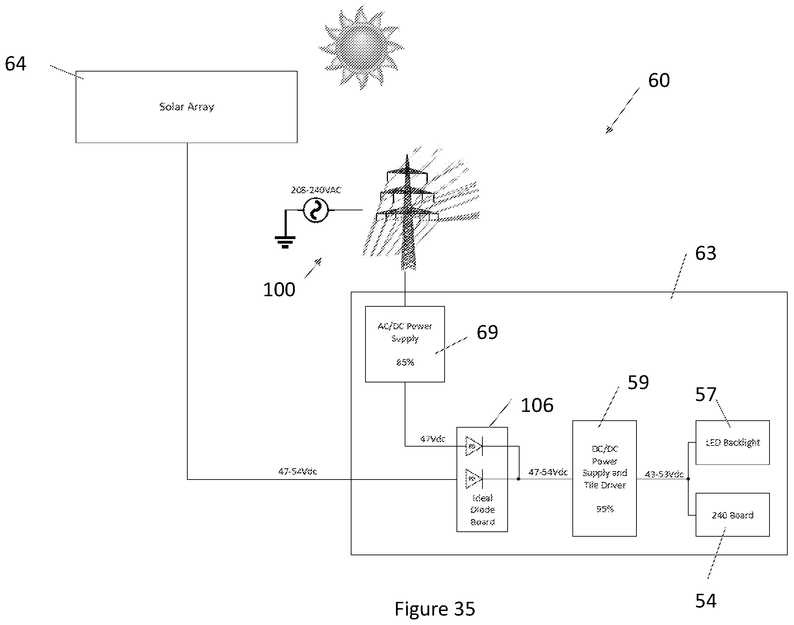

**FIGURE 35** is another exemplary electrical schematic. The solar energy harvesting devices 64 may be placed in electrical connection with the controller 106. The controller 106 may be in electrical connection with the utility power supply 100, such as, but not limited to, by way of an AC/DC power supply 69. The AC/DC power supply 69, in exemplary embodiments, may comprise one or more inverters 108 for converting AC energy from the utility power supply 100 to DC power as required. The controller 106 may be electrically connected to a DC/DC power supply 59. The DC/DC power supply 59 may distribute DC power to backlights 57 and/or various electrical components 55 of the display layer portion 63 and/or other various components of the assembly 60 such as, but not limited to, the display unit 62, sensors, fans, cooling devices, customer equipment, electronics, any combination thereof, or the like.

While certain references are made herein with regards to the assembly 60 and display layer portion 63, the same or similar arrangement may be utilized with regard to the various assemblies 50, 60, 60', 60", 70, 80 and related components.

Exemplary electrical efficiencies are provided at figure 35 by way of non-limiting example to demonstrate the increase in efficiency realized by utilizing a DC/DC system. Such efficiencies may be based on simulated weather conditions based on historical weather and other environmental considerations for a given location.

Any embodiment of the present invention may include any of the features of the other embodiments of the present invention. The exemplary embodiments herein disclosed are not intended to be exhaustive or to unnecessarily limit the scope of the invention. The exemplary embodiments were chosen and described in order to explain the principles of the present invention so that others skilled in the art may practice the invention. Having shown and described exemplary embodiments of the present invention, those skilled in the art will realize that many variations and modifications may be made to the described invention.

Certain operations described herein may be performed by one or more electronic devices. Each electronic device may comprise one or more processors, electronic storage devices, executable software instructions, and the like configured to perform the operations described herein. The electronic devices may be general purpose computers or specialized computing devices. The electronic devices may be personal computers, smartphones, tablets, databases, servers, or the like. The electronic connections described herein may be accomplished by wired or wireless means.

## Claims

1. A solar powered, vehicle mounted display unit (VMDU) (10) for a vehicle (12), said VMDU comprising:
an electronic display (18);
a housing (20) for said electronic display, wherein said housing is is mounted to a first and second cross bar installed to said vehicle such that said first and second crossbars (16) extend laterally across a roof of said vehicle and said housing extends longitudinally along the roof of said vehicle when installed to said first and second crossbars;
a solar energy harvesting device (24) located above, and spaced apart from, said housing, wherein said solar energy harvesting device is electrically connected to said electronic display; support members (36) extending between said housing and said solar energy harvesting device to support said solar energy harvesting device in an elevated position above, and spaced apart from, said housing to create a void between at least part of said solar energy harvesting device and said housing and cause said solar energy harvesting device to at least periodically cast shade on said electronic display; and
stiffeners (34) extending along a lowermost surface of the solar energy harvesting device;
wherein said housing defines a first footprint, said solar energy harvesting device defines a second footprint, said second footprint is larger than, and directly and completely overlies, said first footprint such that;
an outer perimeter of said second footprint extends beyond an outer perimeter of said first footprint in both a lateral and a longitudinal direction.

2. The VMDU of any of claim 1 further comprising:
a controller (42) electrically interposed between said solar energy harvesting device and an alternative power source (40), wherein said controller is configured to monitor power requirements for said display assembly and power generation by said solar energy harvesting device and supply power from said alternative power source when said power generation by said solar energy harvesting device falls below said power requirements for said display assembly.

3. The VMDU of claim 2 wherein:
said solar energy harvesting device is configured to provide direct current ("DC") power; and
said electronic display is configured to operate using DC power.

4. The VMDU of any of claims 2 to 3 wherein:
said alternative power source is configured to supply DC power.

5. The VMDU of any of claims 2 to 4 wherein:
said alternative power source comprises a vehicle battery.

6. The VMDU of any of claims 2 to 5 wherein:
said controller is configured to supply any power generated by said solar energy harvesting device in excess of said power needs for said display assembly to said alternative power source.

7. The VMDU of any preceding claim further comprising:
an open loop pathway (19) for ambient air within said housing; and
one or more fans located within said housing for cooling said electronic display when operated, wherein each of said one or more fans are electrically connected to said controller and are configured to operate using DC power.

8. The VMDU of any preceding claim further comprising:
a closed loop pathway (17) for circulating gas within said housing; and
a heat exchanger (25), wherein said open loop pathway comprises a first portion of said heat exchanger, and wherein said closed loop pathway comprises a second portion of said heat exchanger.

9. The VMDU of any preceding claim wherein:
said electronic display comprises a layer of liquid crystals; and
said electronic display comprises a direct backlight.

10. The VMDU of any preceding claim wherein:
said solar energy harvesting devices has a substantially cuboid form.

11. The VMDU of any preceding claim further comprising:
one or more antennae (30) provided at an upper surface of the solar energy harvesting device.

12. The VMDU of any preceding claim further comprising:
one or more cameras (44) provided at the lowermost surface of the solar energy harvesting device.

## Patentansprüche

1. Solarbetriebene, fahrzeugmontierte Anzeigeeinheit (VMDU) (10) für ein Fahrzeug (12), wobei die VMDU Folgendes umfasst:
eine elektronische Anzeige (18);
ein Gehäuse (20) für die elektronische Anzeige, wobei das Gehäuse an einem ersten und einem zweiten Querträger montiert ist, die an dem Fahrzeug so installiert sind, dass sich der erste und der zweite Querträger (16) seitlich über ein Dach des Fahrzeugs erstrecken und sich das Gehäuse in Längsrichtung entlang des Dachs des Fahrzeugs erstreckt, wenn es an dem ersten und dem zweiten Querträger installiert ist;
eine Vorrichtung (24) zum Sammeln von Solarenergie, die über dem Gehäuse angeordnet und von diesem beabstandet ist, wobei die Vorrichtung zum Sammeln von Solarenergie elektrisch mit der elektronischen Anzeige verbunden ist; Stützelemente (36), die sich zwischen dem Gehäuse und der Vorrichtung zum Sammeln von Solarenergie erstrecken, um die Vorrichtung zum Sammeln von Solarenergie in einer erhöhten Position über dem Gehäuse und von diesem beabstandet zu halten, um einen Hohlraum zwischen mindestens einem Teil der Vorrichtung zum Sammeln von Solarenergie und dem Gehäuse zu schaffen und zu bewirken, dass die Vorrichtung zum Sammeln von Solarenergie mindestens zeitweise Schatten auf die elektronische Anzeige wirft; und
Versteifungen (34), die sich entlang der untersten Fläche der Vorrichtung zum Sammeln von Solarenergie erstrecken;
wobei das Gehäuse eine erste Grundfläche definiert, die Vorrichtung zum Sammeln von Solarenergie eine zweite Grundfläche definiert, die zweite Grundfläche größer als die erste Grundfläche ist und direkt und vollständig darüber liegt, sodass:
ein äußerer Umfang der zweiten Grundfläche sich über einen äußeren Umfang der ersten Grundfläche sowohl in einer seitlichen als auch in einer Längsrichtung erstreckt.

2. VMDU nach Anspruch 1, ferner umfassend:
eine Steuerung (42), die elektrisch zwischen der Vorrichtung zum Sammeln von Solarenergie und einer alternativen Energiequelle (40) angeordnet ist, wobei die Steuerung dazu konfiguriert ist, den Energiebedarf für die Anzeigebaugruppe und die Energieerzeugung durch die Vorrichtung zum Sammeln von Solarenergie zu überwachen und Energie von der alternativen Energiequelle zuzuführen, wenn die Energieerzeugung durch die Vorrichtung zum Sammeln von Solarenergie unter den Energiebedarf für die Anzeigebaugruppe fällt.

3. VMDU nach Anspruch 2, wobei:
die Vorrichtung zum Sammeln von Solarenergie dazu konfiguriert ist, Gleichstrom (''DC-Strom") bereitzustellen; und
die elektronische Anzeige dazu konfiguriert ist, mit DC-Strom betrieben zu werden.

4. VMDU nach einem der Ansprüche 2 bis 3, wobei:
die alternative Energiequelle dazu konfiguriert ist, DC-Strom zuzuführen.

5. VMDU nach einem der Ansprüche 2 bis 4, wobei:
die alternative Energiequelle eine Fahrzeugbatterie umfasst.

6. VMDU nach einem der Ansprüche 2 bis 5, wobei:
die Steuerung dazu konfiguriert ist, die durch die Vorrichtung zum Sammeln von Solarenergie erzeugte Energie, die den Energiebedarf der Anzeigebaugruppe übersteigt, der alternativen Energiequelle bereitzustellen.

7. VDMU nach einem der vorhergehenden Ansprüche, ferner umfassend:
einen offenen Kreislauf (19) für die Umgebungsluft innerhalb des Gehäuses; und
ein oder mehrere Lüfter, die sich innerhalb des Gehäuses befinden, um die elektronische Anzeige zu kühlen, wenn sie in Betrieb ist, wobei jeder von dem einen oder den mehreren Lüftern elektrisch mit der Steuerung verbunden und dazu konfiguriert ist, mit DC-Strom betrieben zu werden.

8. VDMU nach einem der vorhergehenden Ansprüche, ferner umfassend:
einen geschlossenen Kreislauf (17) zum Zirkulieren von Gas innerhalb des Gehäuses; und
einen Wärmetauscher (25), wobei der offene Kreislauf einen ersten Abschnitt des Wärmetauschers umfasst und wobei der geschlossene Kreislauf einen zweiten Abschnitt des Wärmetauschers umfasst.

9. VMDU nach einem der vorhergehenden Ansprüche, wobei:
die elektronische Anzeige eine Schicht aus Flüssigkristallen umfasst; und
die elektronische Anzeige eine direkte Hintergrundbeleuchtung umfasst.

10. VDMU nach einem der vorhergehenden Ansprüche, wobei:
die Vorrichtungen zum Sammeln von Solarenergie eine im Wesentlichen quaderförmige Form aufweisen.

11. VDMU nach einem der vorhergehenden Ansprüche, ferner umfassend:
eine oder mehrere Antennen (30), die an der Oberseite der Vorrichtung zum Sammeln von Solarenergie bereitgestellt sind.

12. VDMU nach einem der vorhergehenden Ansprüche, ferner umfassend:
eine oder mehrere Kameras (44), die an der untersten Seite der Vorrichtung zum Sammeln von Solarenergie bereitgestellt sind.

## Revendications

1. Unité d'affichage embarquée (VMDU) (10) alimentée par l'énergie solaire pour un véhicule (12), ladite VMDU comprenant :
un affichage électronique (18) ;
un boîtier (20) pour ledit affichage électronique, dans laquelle ledit boîtier est monté sur une première et une seconde barre transversale installées sur ledit véhicule de sorte que lesdites première et seconde barres transversales (16) se prolongent latéralement sur un toit dudit véhicule et ledit boîtier se prolonge longitudinalement le long du toit dudit véhicule lorsqu'il est installé sur lesdites première et seconde barres transversales ;
un dispositif de récupération d'énergie solaire (24) situé au-dessus et à distance dudit boîtier, dans laquelle ledit dispositif de récupération d'énergie solaire est connecté électriquement audit affichage électronique ; des éléments de support (36) se prolongeant entre ledit boîtier et ledit dispositif de récupération d'énergie solaire pour soutenir ledit dispositif de récupération d'énergie solaire en position surélevée au-dessus et à distance dudit boîtier afin de créer un vide entre au moins une partie dudit dispositif de récupération d'énergie solaire et ledit boîtier et de faire en sorte que ledit dispositif de récupération d'énergie solaire projette au moins périodiquement de l'ombre sur ledit affichage électronique ; et
des raidisseurs (34) se prolongeant le long d'une surface la plus basse du dispositif de récupération d'énergie solaire ;
dans laquelle ledit boîtier définit une première empreinte, ledit dispositif de récupération d'énergie solaire définit une seconde empreinte, ladite seconde empreinte est plus grande que, et recouvre directement et complètement, ladite première empreinte de sorte que ;
un périmètre extérieur de ladite seconde empreinte se prolonge au-delà d'un périmètre extérieur de ladite première empreinte dans une direction latérale et longitudinale.

2. VMDU selon l'une quelconque de la revendication 1 comprenant également :
un dispositif de commande (42) interposé électriquement entre ledit dispositif de récupération d'énergie solaire et une source d'énergie alternative (40), dans laquelle ledit dispositif de commande est configuré pour surveiller les besoins en énergie pour ledit ensemble d'affichage et la production d'énergie par ledit dispositif de récupération d'énergie solaire et fournir de l'énergie à partir de ladite source d'énergie alternative lorsque ladite production d'énergie par ledit dispositif de récupération d'énergie solaire tombe en dessous desdits besoins en énergie pour ledit ensemble d'affichage.

3. VMDU selon la revendication 2 dans laquelle :
ledit dispositif de récupération d'énergie solaire est configuré pour fournir une alimentation en courant continu (« CC ») ; et
ledit affichage électronique est configuré pour fonctionner à l'aide d'une alimentation CC.

4. VMDU selon l'une quelconque des revendications 2 à 3 dans laquelle :
ladite source d'alimentation alternative est configurée pour fournir une alimentation CC.

5. VMDU selon l'une quelconque des revendications 2 à 4 dans laquelle :
ladite source d'énergie alternative comprend une batterie de véhicule.

6. VMDU selon l'une quelconque des revendications 2 à 5 dans laquelle :
ledit dispositif de commande est configuré pour fournir toute puissance générée par ledit dispositif de récupération d'énergie solaire dépassant lesdits besoins en puissance pour ledit ensemble d'affichage à ladite source d'alimentation alternative.

7. VMDU selon une quelconque revendication précédente comprenant également :
un chemin en boucle ouverte (19) pour l'air ambiant à l'intérieur dudit boîtier ; et
un ou plusieurs ventilateurs situés à l'intérieur dudit boîtier pour refroidir ledit affichage électronique lorsqu'il est utilisé, dans laquelle chacun desdits un ou plusieurs ventilateurs est connecté électriquement audit dispositif de commande et est configuré pour fonctionner à l'aide d'une alimentation CC.

8. VMDU selon une quelconque revendication précédente comprenant également :
un chemin en boucle fermée (17) pour faire circuler le gaz à l'intérieur dudit boîtier ; et
un échangeur de chaleur (25), dans laquelle ledit trajet en boucle ouverte comprend une première partie dudit échangeur de chaleur, et dans laquelle ledit trajet en boucle fermée comprend une seconde partie dudit échangeur de chaleur.

9. VMDU selon une quelconque revendication précédente dans laquelle :
ledit affichage électronique comprend une couche de cristaux liquides ; et
ledit affichage électronique comprend un rétroéclairage direct.

10. VMDU selon une quelconque revendication précédente dans laquelle :
lesdits dispositifs de récupération d'énergie solaire présentent une forme sensiblement cuboïde.

11. VMDU selon une quelconque revendication précédente comprenant également :
une ou plusieurs antennes (30) prévues au niveau d'une surface supérieure du dispositif de récupération d'énergie solaire.

12. VMDU selon une quelconque revendication précédente comprenant également :
une ou plusieurs caméras (44) prévues au niveau de la surface la plus basse du dispositif de récupération d'énergie solaire.
